# EUROPEAN PATENT APPLICATION

(11) **EP 4 852 690 A1**
(43) Date of publication of application: **09.12.2026**
(21) Application number: 25752050.2
(22) Date of filing: 28.01.2025
(51) Int. Cl.: H10N 30/853, C30B 1/02, C30B 29/22, H02N 2/12, H04R 17/00, H10N 30/01, H10N 30/20, H10N 30/077, H10N 30/85, H10N 30/095

(54) **PIEZOELECTRIC ELEMENT, METHOD FOR MANUFACTURING PIEZOELECTRIC ELEMENT, ULTRASONIC MOTOR, OPTICAL APPARATUS, VIBRATION DEVICE, DUST REMOVAL DEVICE, IMAGING DEVICE, ULTRASONIC PROBE, ULTRASONIC DIAGNOSTIC DEVICE, ULTRASONIC DIAGNOSTIC SYSTEM, AND ELECTRONIC APPARATUS**

(30) Priority: 05.02.2024 JP 2024015528; 10.12.2024 JP 2024215920
(71) Applicant: Canon Kabushiki Kaisha, Tokyo 146-8501 (JP)
(72) Inventor: MATSUDA, Takanori, Tokyo 146-8501 (JP); FURUTA, Tatsuo, Tokyo 146-8501 (JP)
(74) Representative: WESER & Kollegen Patentanwälte PartmbB
(86) International application number: PCT/JP2025/002626
(87) International publication number: WO 2025/169796

(57) **Abstract**

Provided is a piezoelectric element that can achieve both of a high electromechanical coupling coefficient and a high coercive electric field, and that can be applied to a wider range of perovskite-type oxide single crystals. The piezoelectric element is a piezoelectric element including a single crystal of a perovskite-type metal oxide and electrodes facing each other, wherein when an environmental temperature is 25°C, a crystal system of the single crystal is a tetragonal system, and wherein a crystal orientation of a surface of the single crystal in contact with each of electrode surfaces of the electrodes facing each other is (110) or (111).

## Description

### [Technical Field]

The present invention relates to a piezoelectric element and a method of producing a piezoelectric element. The present invention also relates to an ultrasonic motor, an optical apparatus, a vibration device, a dust removing device, an image pickup apparatus, an ultrasonic probe, an ultrasonic diagnostic apparatus, an ultrasonic diagnostic system, and an electronic apparatus each using the piezoelectric element.

### [Background Art]

In a piezoelectric body of a perovskite-type oxide, a single crystal material is used to obtain high piezoelectric performance. In a lead-based perovskite-type oxide, an electromechanical coupling coefficient k₃₃ is as large as 90% or more. However, the coercive electric field indicating the withstand voltage is small as compared to a polycrystalline material, and a voltage that can be applied is limited. In Patent Literature 1, there is described a PMN-PT-based single crystal. Although a material design emphasizes a high dielectric constant and high piezoelectric performance, a crystal system is a pseudo-cubic system, and a coercive electric field Ec does not become large.

As a result of extensive studies by the inventors of the present invention, it has been found that both of a high electromechanical coupling coefficient and a high coercive electric field can be achieved by producing an element having a (110) or (111) orientation capable of polarizing a single crystal of a tetragonal perovskite-type oxide in an orientation different from an easy polarization axis.

### [Citation List]

### [Patent Literature]

PTL 1: Japanese Patent No. 5156065

### [Summary of Invention]

### [Technical Problem]

In a single crystal material of a perovskite-type oxide, it has been difficult to achieve both of a high electromechanical coupling coefficient and a high coercive electric field.

The present invention has been made to solve such problem, and is directed to providing a piezoelectric element that can be applied to a wider range of perovskite-type oxide single crystals. The present invention is also directed to providing a method of producing the above-mentioned piezoelectric element.

The present invention is also directed to providing a single crystal piezoelectric element having a large mechanical quality factor and a large coercive electric field, and is also directed to providing an ultrasonic motor, an optical apparatus, a vibration device, a dust removing device, an image pickup apparatus, an ultrasonic probe, an ultrasonic diagnostic apparatus, an ultrasonic diagnostic system, and an electronic apparatus each using the above-mentioned piezoelectric element.

### [Solution to Problem]

In order to solve the above-mentioned problem, according to the present invention, there is provided a piezoelectric element including a single crystal of a perovskite-type metal oxide and electrodes facing each other, wherein when an environmental temperature is 25°C, a crystal system of the single crystal is a tetragonal system, and wherein a crystal orientation of a surface of the single crystal in contact with each of electrode surfaces of the electrodes facing each other is (110) or (111).

In addition, according to the present invention, there is provided a method of producing a piezoelectric element, the method including:
a first preparation step of preparing a matrix and a seed single crystal;
a second preparation step of preparing an integrated body in which a surface of the matrix and a (110) plane or a (111) plane of the seed single crystal are arranged in contact with each other;
a first temperature-increasing step of increasing a temperature of the integrated body from room temperature to a liquid-phase start temperature of the matrix;
a second temperature-increasing step of increasing the temperature of the integrated body from the liquid-phase start temperature to a liquid-phase end temperature of the matrix;
a heating step of heating the integrated body at the liquid-phase end temperature;
a step of obtaining a single crystal from the integrated body after the heating;
a step of arranging electrodes facing each other on the single crystal to produce a piezoelectric element; and
a step of subjecting the piezoelectric element to polarization treatment,
wherein a rate of temperature increase in the second temperature-increasing step is lower than a rate of temperature increase in the first temperature-increasing step.

In addition, according to the present invention, there is provided an ultrasonic motor including at least: a vibrating body including the piezoelectric element; and a moving body configured to be brought into contact with the vibrating body.

In addition, according to the present invention, there is provided an optical apparatus including a drive unit including the ultrasonic motor.

In addition, according to the present invention, there is provided a vibration device including a vibrating body including a diaphragm including the piezoelectric element.

In addition, according to the present invention, there is provided a dust removing device including a vibration unit including the vibration device.

In addition, according to the present invention, there is provided an image pickup apparatus including at least: the dust removing device; and an image pickup element unit, wherein the diaphragm of the dust removing device is arranged on a light-receiving surface side of the image pickup element unit.

In addition, according to the present invention, there is provided an ultrasonic probe including the piezoelectric element, the ultrasonic probe being configured to transmit and receive a signal by the piezoelectric element.

In addition, according to the present invention, there is provided an ultrasonic diagnostic apparatus including at least: the ultrasonic probe; and an image output unit.

In addition, according to the present invention, there is provided an ultrasonic diagnostic system including: the ultrasonic probe; a transmission unit configured to transmit a signal output from the ultrasonic probe; and a reception unit configured to receive the signal transmitted from the transmission unit.

In addition, according to the present invention, there is provided an electronic apparatus including a piezoelectric acoustic component including the piezoelectric element.

### [Advantageous Effects of Invention]

According to the present invention, the piezoelectric element that simultaneously achieves a high electromechanical coupling coefficient and a high coercive electric field, which have been difficult in a conventional single crystal material of a perovskite-type oxide, can be obtained.

### [Brief Description of Drawings]

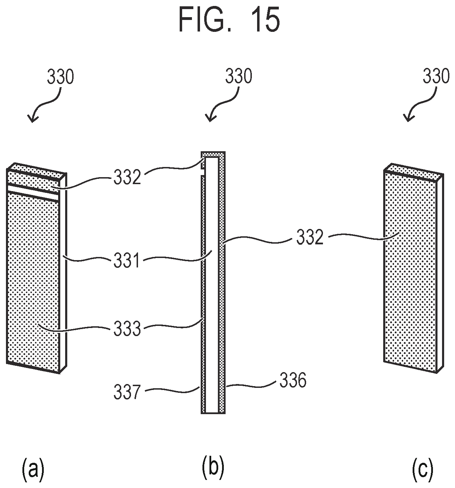

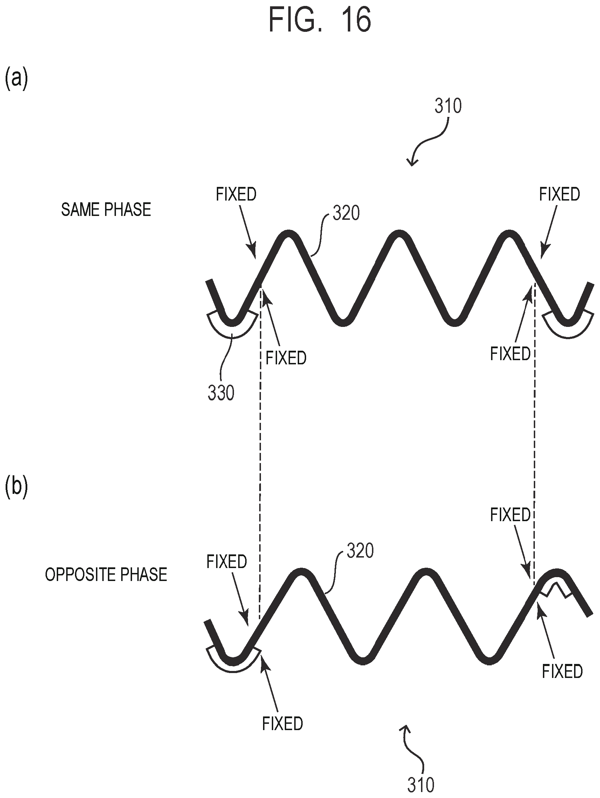

[Fig. 1]

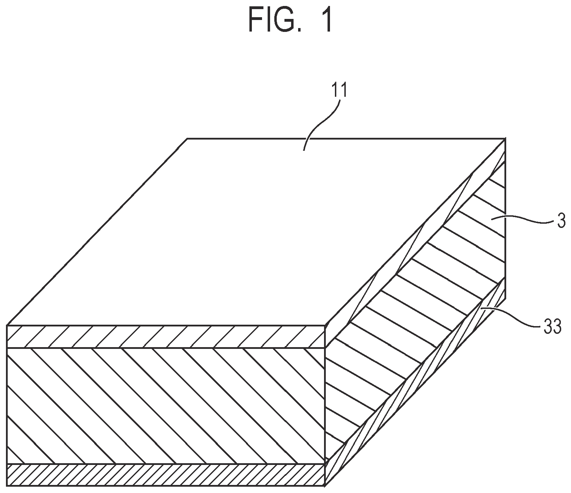

   Fig. 1 is a schematic view for illustrating the configuration of a piezoelectric element according to one embodiment of the present invention.
[Fig. 2]

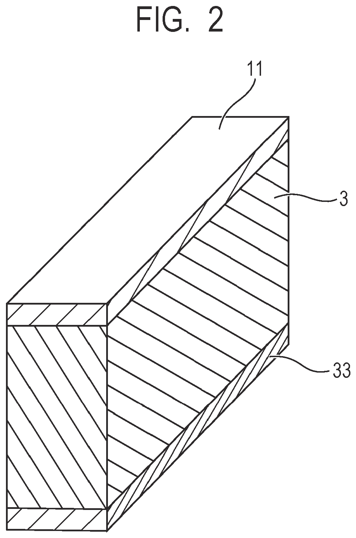

   Fig. 2 is a schematic view for illustrating the configuration of the piezoelectric element according to one embodiment of the present invention.
[Fig. 3A]

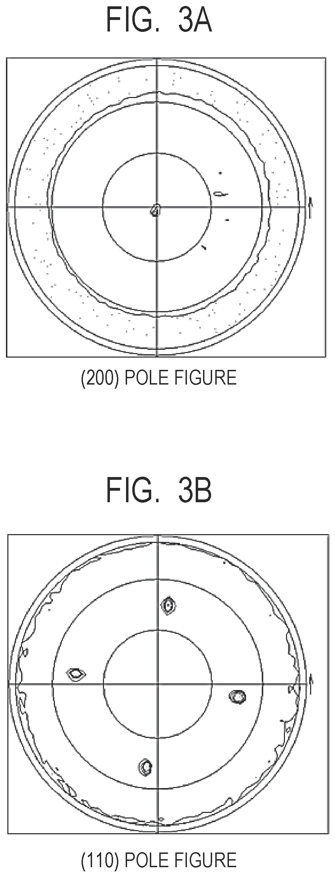

   Fig. 3A is a schematic view for illustrating an example of the pole figure measurement of the X-ray diffraction of a (100) single crystal for forming the piezoelectric element of the present invention.
[Fig. 3B]
   Fig. 3B is a schematic view for illustrating another example of the pole figure measurement of the X-ray diffraction of the (100) single crystal for forming the piezoelectric element of the present invention.
[Fig. 4A]

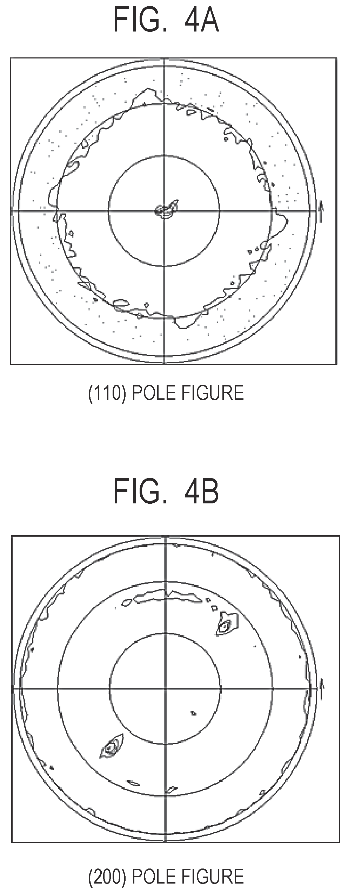

   Fig. 4A is a schematic view for describing an example of the pole figure measurement of the X-ray diffraction of a (110) single crystal for forming the piezoelectric element of the present invention.
[Fig. 4B]
   Fig. 4B is a schematic view for describing another example of the pole figure measurement of the X-ray diffraction of the (110) single crystal for forming the piezoelectric element of the present invention.
[Fig. 5A]

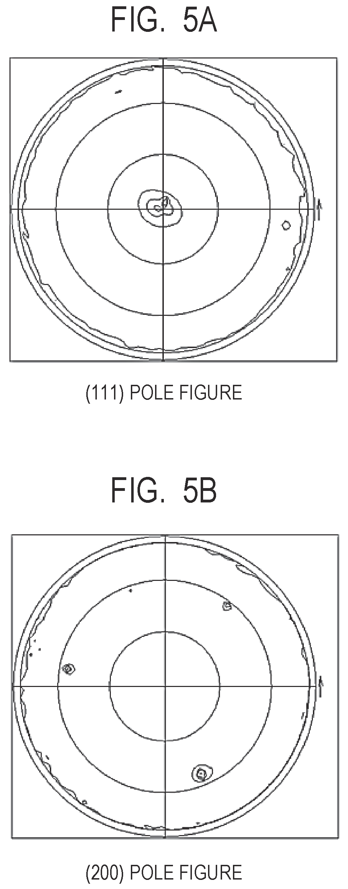

   Fig. 5A is a schematic view for describing an example of the pole figure measurement of the X-ray diffraction of a (111) single crystal for forming the piezoelectric element of the present invention.
[Fig. 5B]
   Fig. 5B is a schematic view for describing another example of the pole figure measurement of the X-ray diffraction of the (111) single crystal for forming the piezoelectric element of the present invention.
[Fig. 6]

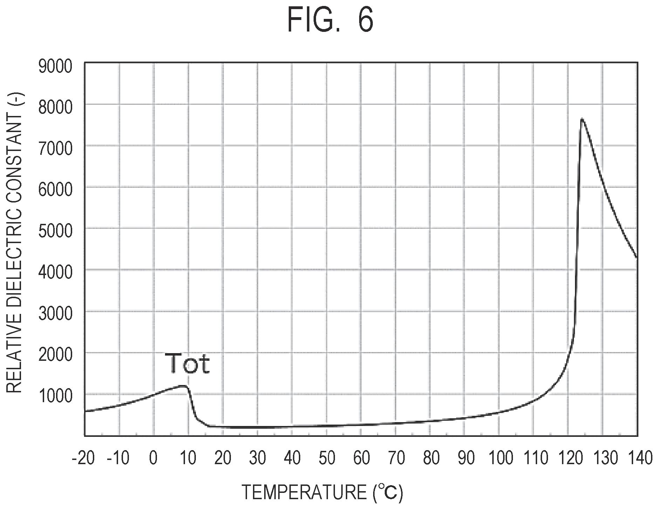

   Fig. 6 is a graph for describing an example of the dielectric constant temperature characteristic of the piezoelectric element of the present invention.
[Fig. 7]

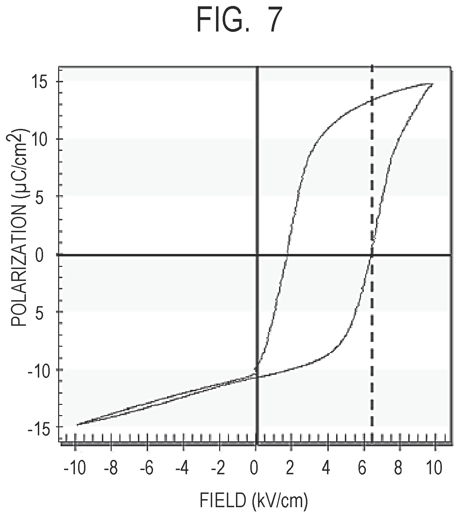

   Fig. 7 is a graph for describing an example of the PE hysteresis curve of the piezoelectric element of the present invention.
[Fig. 8A]

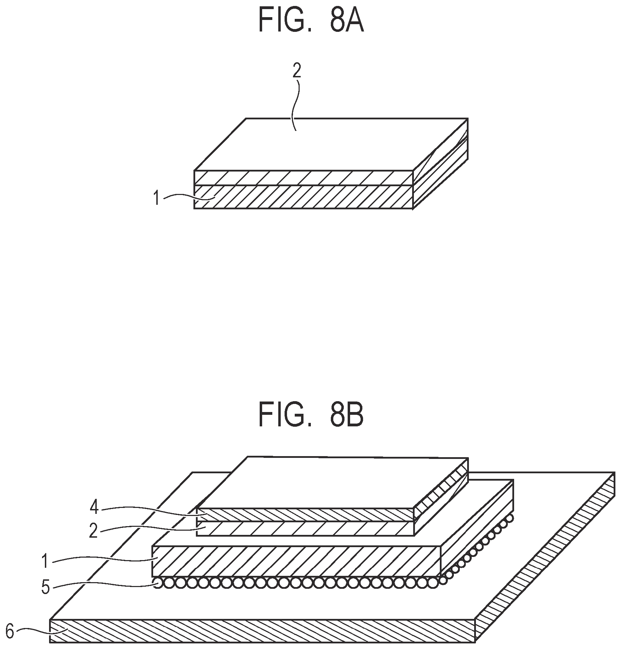

   Fig. 8A is a schematic view for describing an example of the configuration for producing a single crystal of the present invention.
[Fig. 8B]
   Fig. 8B is a schematic view for describing another example of the configuration for producing a single crystal of the present invention.
[Fig. 9]

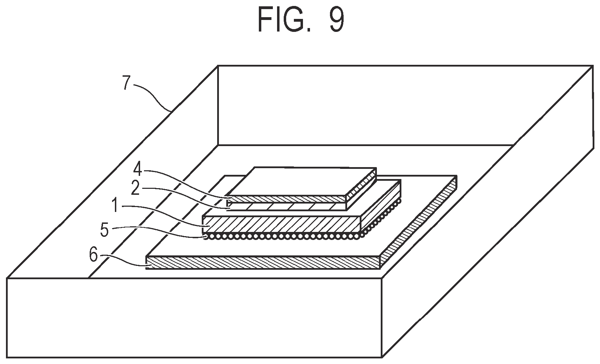

   Fig. 9 is a schematic view for illustrating another example of the configuration for producing a single crystal of the present invention.
[Fig. 10]

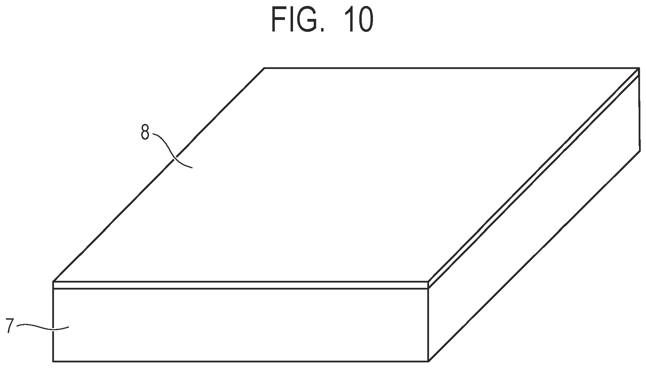

   Fig. 10 is a schematic view for illustrating another example of the configuration for producing a single crystal of the present invention.
[Fig. 11]

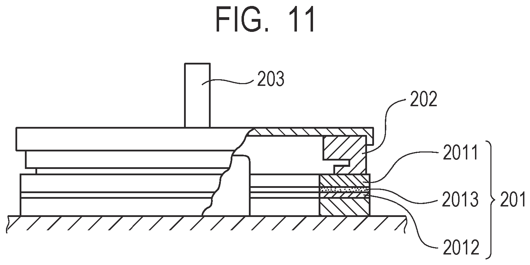

   Fig. 11 is a schematic view for illustrating the configuration of an ultrasonic motor according to one embodiment of the present invention.
[Fig. 12A]

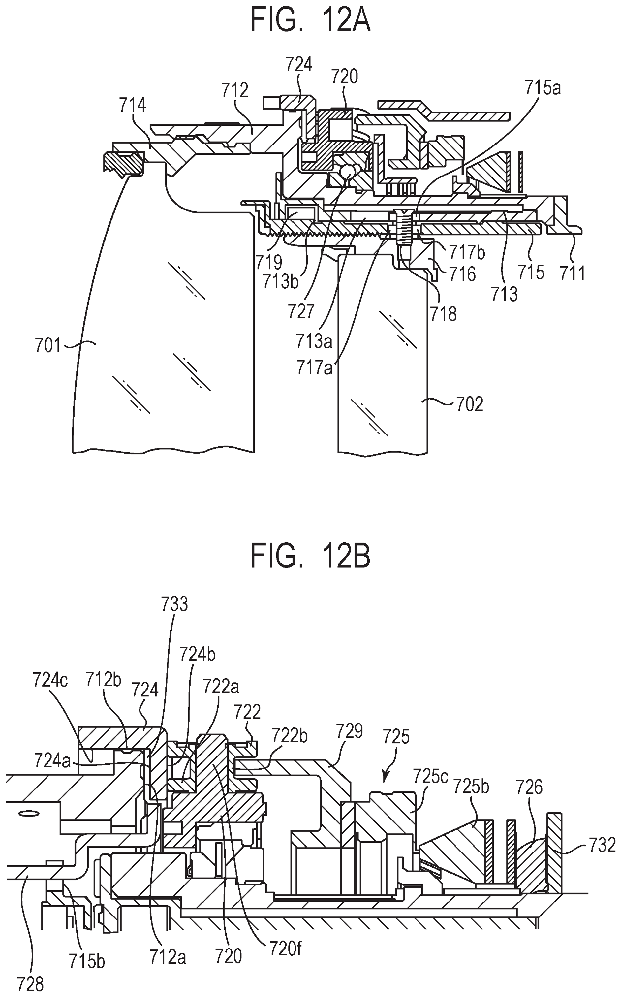

   Fig. 12A is a schematic view for illustrating an optical apparatus according to one embodiment of the present invention.
[Fig. 12B]
   Fig. 12B is an enlarged view of the upper right portion of Fig. 12A.
[Fig. 13]

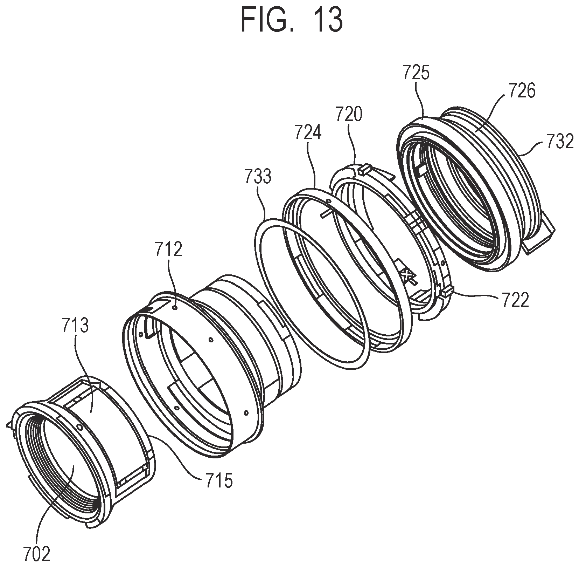

   Fig. 13 is a schematic view for illustrating the optical apparatus according to one embodiment of the present invention.
[Fig. 14A]

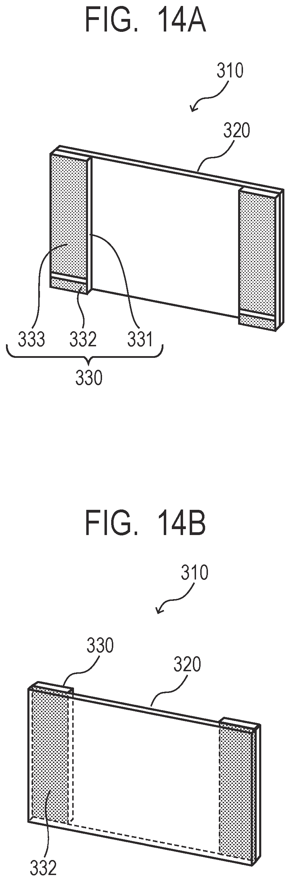

   Fig. 14A is an example of a schematic view for illustrating one embodiment in the case where a vibration device of the present invention is used as a dust removing device.
[Fig. 14B]
   Fig. 14B is another example of the schematic view for illustrating one embodiment in the case where the vibration device of the present invention is used as the dust removing device.
[Fig. 15]
   Parts (a) to (c) of Fig. 15 are schematic views for illustrating the configuration of the piezoelectric element in the dust removing device of the present invention.
[Fig. 16]
   Parts (a) and (b) of Fig. 16 are schematic views for illustrating the vibration principle of the dust removing device of the present invention.
[Fig. 17]

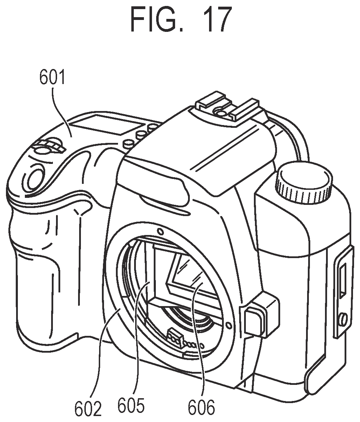

   Fig. 17 is a schematic view for illustrating an image pickup apparatus according to one embodiment of the present invention.
[Fig. 18]

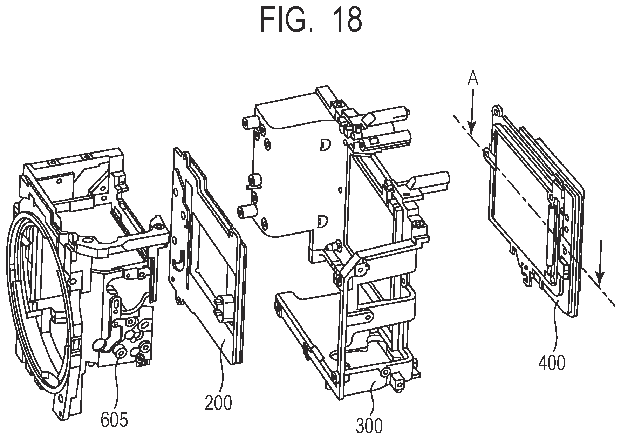

   Fig. 18 is a schematic view for illustrating the image pickup apparatus according to one embodiment of the present invention.
[Fig. 19]

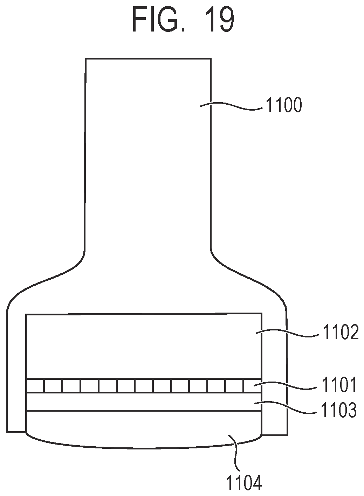

   Fig. 19 is a schematic view for illustrating an ultrasonic probe according to one embodiment of the present invention.
[Fig. 20]

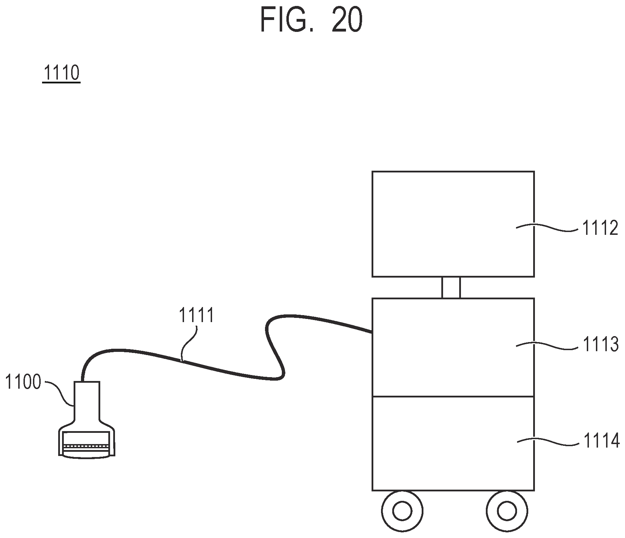

   Fig. 20 is a schematic view for illustrating an ultrasonic diagnostic apparatus according to one embodiment of the present invention.
[Fig. 21]

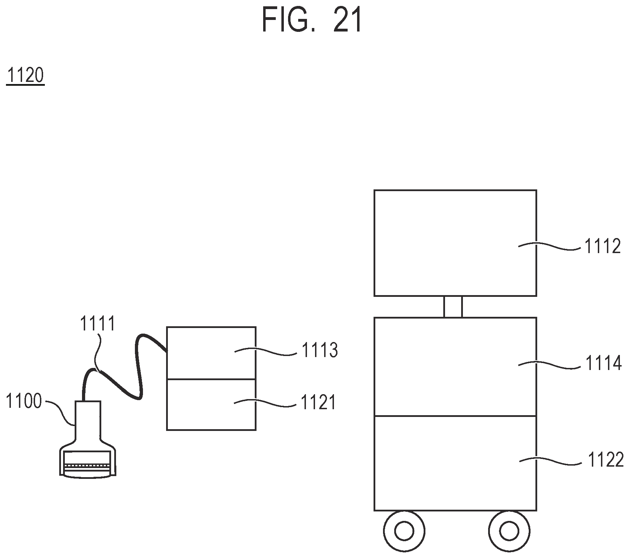

   Fig. 21 is a schematic view for illustrating an ultrasonic diagnostic system according to one embodiment of the present invention.
[Fig. 22]

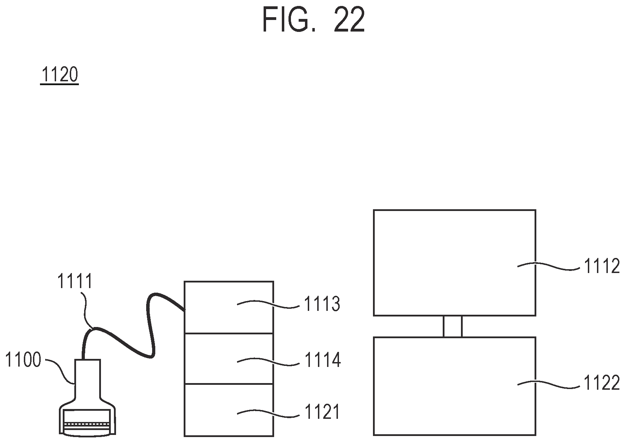

   Fig. 22 is a schematic view for illustrating the ultrasonic diagnostic system according to one embodiment of the present invention.
[Fig. 23]

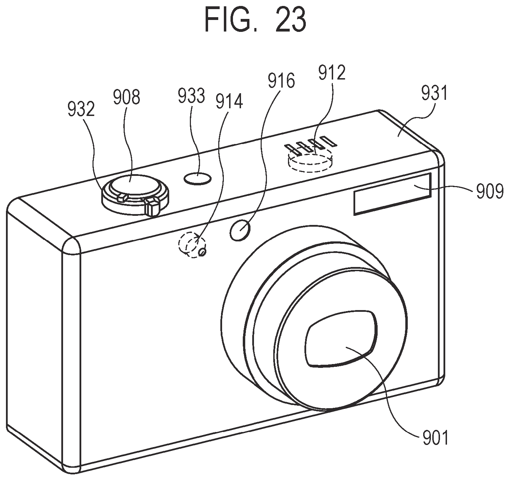

   Fig. 23 is a schematic view for illustrating an electronic apparatus according to one embodiment of the present invention.

### [Description of Embodiments]

### <<First Embodiment>>

A first embodiment relates to a piezoelectric element.

A piezoelectric element of the present invention is a piezoelectric element including a single crystal of a perovskite-type metal oxide and electrodes facing each other, wherein when an environmental temperature is 25°C, a crystal system of the single crystal is a tetragonal system, and wherein a crystal orientation of a surface of the single crystal in contact with each of electrode surfaces of the electrodes facing each other is (110) or (111).

An embodiment of the present invention is described below.

According to the present invention, there is provided a single crystal piezoelectric element that simultaneously achieves a high electromechanical coupling coefficient and a high coercive electric field, which have been difficult in a conventional single crystal material of a perovskite-type oxide.

In addition, the single crystal element of the present invention can be used for various applications, such as electronic devices, light-emitting elements, optical elements, energy conversion elements, and sensors.

### <Description for understanding the Invention>

### (Single Crystal)

A single crystal that is a piezoelectric body for forming the piezoelectric element is formed of a single crystal grain, and inside the crystal grain, crystal axes, which represent the directions of atomic arrangement, are all the same in any part. However, the single crystal of the present invention may contain lattice defects such as dislocations, vacancies, and voids inside the single crystal. In addition, the single crystal may contain a domain structure produced by a difference in crystal system based on phase transition, a difference in direction of spontaneous polarization, or the like.

### (Perovskite-type)

The perovskite-type refers to a perovskite structure (also referred to as "perovskite structure"), which is ideally a cubic structure, as described in the 5th edition of the Iwanami Physics and Chemical Dictionary (Iwanami Shoten, Publishers, published on February 20, 1998). A perovskite-type oxide is generally represented by the chemical formula ABO₃. The molar ratio of an A-site or B-site element to an O element is described as 1:3. However, even in the case where the ratio between element amounts slightly deviates therefrom (e.g., from 1.00:2.94 to 1.00:3.06), when the oxide has a perovskite type as a main phase, the oxide can be said to be a perovskite-type oxide.

In addition, when the A element, the B element, and the O element are slightly shifted in coordinates from the symmetric positions of a unit cell, the unit cell of the perovskite type is distorted, resulting in a crystal system, such as a tetragonal, rhombohedral, or orthorhombic system. The single crystal of the present invention is preferably formed of a perovskite-type oxide. However, the crystal system of the single crystal may be any crystal system depending on a single or a plurality of elements for forming A and B. Whether the oxide is of a perovskite type and what the crystal system of the single crystal is may be determined, for example, by structural analysis through X-ray diffraction or electron beam diffraction. In this case, a sample may be pulverized before measurement as required.

### <Piezoelectric Element>

### (Perovskite-type Oxide Piezoelectric Single Crystal 1)

The perovskite-type single crystal that is a piezoelectric body for forming the piezoelectric element of the present invention may contain Pb, Mg, Nb, and Ti.

### (Tetragonal System)

In the piezoelectric element of the present invention, when an environmental temperature is 25°C, the crystal system of the single crystal is a tetragonal system. The perovskite-type single crystal may contain, as a main component, a perovskite-type metal oxide represented by the following general formula (2).

(1-y)Pb(Mg_{1/3}Nb_{2/3})O₃-yPbTiO₃ (2)

When "y" in the formula falls within the range of 0.34≤y≤0.50, a single crystal that adopts a tetragonal crystal system can be stably produced under an environmental temperature of 25°C.

### (Perovskite-type Oxide Piezoelectric Single Crystal 2)

The perovskite-type single crystal that is a piezoelectric body for forming the piezoelectric element of the present invention may contain Pb, Zn, Nb, and Ti.

### (Tetragonal System)

In the piezoelectric element of the present invention, when an environmental temperature is 25°C, the crystal system of the single crystal is a tetragonal system. The perovskite-type single crystal may contain, as a main component, a perovskite-type metal oxide represented by the following general formula (3).

(1-z)Pb(Zn_{1/3}Nb_{2/3})O₃-zPbTiO₃ (3)

When "z" in the formula falls within the range of 0.12≤z≤0.20, a single crystal that adopts a tetragonal crystal system can be stably produced under an environmental temperature of 25°C.

### (Evaluation of Crystal System and Crystal Orientation)

In the piezoelectric element of the present invention, the single crystal is a tetragonal system under an environmental temperature of 25°C. In addition, in the piezoelectric element of the present invention, when the environmental temperature is 0°C or more to 60°C or less, the crystal system of the perovskite-type metal oxide is preferably tetragonal. The ratio c/a of a c-axis length to an a-axis length is large in a tetragonal single crystal as compared to other crystal systems, and hence spontaneous polarization is large, and polarization after polarization treatment is large. The large polarization can increase a threshold for changing a direction with respect to an external electric field. That is, a coercive electric field can be increased.

### (Perovskite-type Oxide Piezoelectric Single Crystal 3)

In the piezoelectric element of the present invention, the perovskite-type single crystal preferably contains Ba, Ti, and Zr. In the piezoelectric element of the present invention, the molar ratio "x" of the amount of substance of Zr to the total amount of the amount of substance of Ti and the amount of substance of Zr preferably satisfies 0.01≤x≤0.03. In the piezoelectric element of the present invention, the molar ratio α of the amount of substance of Ba to the total amount of the amount of substance of Ti and the amount of substance of Zr preferably satisfies 0.976≤α≤1.020. In the piezoelectric element of the present invention, it is preferred that: the single crystal contain at least Mn and Bi; the content of the Mn be 0.0020 part by mole or more to 0.0500 part by mole or less with respect to 1 part by mole of a perovskite-type metal oxide containing Ba, Ti, and Zr; and the content of the Bi be 0.0005 part by mole or more to 0.0060 part by mole or less with respect to 1 part by mole of the perovskite-type metal oxide containing Ba, Ti, and Zr. In the piezoelectric element of the present invention, the crystal system of the single crystal is a tetragonal system at an environmental temperature of 25°C.

In addition, it is preferred that: the piezoelectric element of the present invention include, as the perovskite-type single crystal that is a piezoelectric body for forming the piezoelectric element of the present invention, a single crystal containing a main component containing a perovskite-type metal oxide represented by the following general formula (1), a first sub-component formed of Mn, and a second sub-component formed of trivalent Bi, and electrodes facing each other; the content of the Mn be 0.0020 part by mole or more to 0.0500 part by mole or less with respect to 1 part by mole of a perovskite-type metal oxide containing Ba, Ti, and Zr; and the content of Bi be 0.0005 part by mole or more to 0.0060 part by mole or less with respect to 1 part by mole of the perovskite-type metal oxide containing Ba, Ti, and Zr.

Ba_{α}(Ti₁₋ₓZrₓ)O₃ (1)

When "x" in the formula falls within the range of 0.01≤x≤0.03 and α in the formula falls within the range of 0.976≤α≤1.020, a single crystal that adopts a tetragonal crystal system can be stably produced under an environmental temperature of 25°C.

The single crystal containing the perovskite-type oxide containing Ba, Ti, and Zr, and Mn and Bi has piezoelectricity, and has a high electromechanical coupling coefficient and a high coercive electric field among lead-free piezoelectric materials.

When the single crystal having piezoelectricity is used for an ultrasonic motor, a high electromechanical coupling coefficient and a large coercive electric field are required. A vibration amplitude cannot be obtained and a driving force as an ultrasonic motor cannot be obtained when the electromechanical coupling coefficient is low. A large coercive electric field is required for increasing a driving voltage in order to obtain the vibration amplitude, and the vibration amplitude cannot be obtained also when the coercive electric field is small.

In addition, when the single crystal is used as an ultrasonic probe, a high electromechanical coupling coefficient and a large coercive electric field are required. Broadband transmission and reception characteristics cannot be obtained with a low electromechanical coupling coefficient.

The oxide represented by the general formula (1) means that the element located at the A site is Ba, and the elements located at the B site are Ti and Zr. However, part of Ba may be located at the B site. Similarly, part of Ti and Zr may be located at the A site.

In the general formula (1), the molar ratio of the B-site elements to the O element is 1:3, but the ratio between element amounts may slightly deviate therefrom (e.g., from 1.00:2.94 to 1.00:3.06).

In the single crystal of the present invention, α, which represents the ratio of the molar amount of Ba at the A site to the molar amounts of Ti and Zr at the B site in the general formula (1), preferably falls within the range of 0.976≤α≤1.020.

The perovskite-type single crystal that is a piezoelectric body for forming the piezoelectric element of the present invention preferably contains, as a main component, 90 mol% or more of the perovskite-type oxide represented by the general formula (1). A more preferred range is 95 mol% or more.

When α is less than 0.976, a large number of voids may be formed to cause a reduction in strength. Meanwhile, when α is more than 1.020, the grain diameter of the matrix 1 becomes excessively large in the first temperature-increasing step so that the single crystal is less likely to expand during the heating, resulting in that it may be difficult to produce a single crystal.

A preferred range of α in which the voids reduce and the single crystal is likely to expand is 0.980≤α≤1.000.

In the general formula (1), "x", which represents the molar ratio of Zr at the B site, preferably falls within the range of 0.01≤x≤0.03. When "x" is more than 0.03, the crystal system at room temperature of 25°C is not a tetragonal system but an orthorhombic system, a coercive electric field is small, and hence a withstand voltage property becomes insufficient. When "x" is less than 0.01, a piezoelectric constant at room temperature reduces.

Means for measuring the composition of the single crystal of the present invention is not particularly limited. Examples of the means include X-ray fluorescence analysis, ICP emission spectrometry, and atomic absorption spectrometry. In any of the means, the weight ratio and composition ratio of each element in the single crystal can be calculated.

When the content of Mn in the single crystal of the present invention is 0.0020 part by mole or more to 0.0500 part by mole or less with respect to 1 part by mole of the metal oxide, the coercive electric field increases at room temperature of 25°C. Mn is not limited to metal Mn, is only required to be incorporated into the single crystal as a Mn component, and may be incorporated in any form. For example, Mn may be formed into a solid solution at the B site or may be incorporated into an interface with voids in the single crystal. Alternatively, the Mn component may be incorporated into the single crystal in the form of a metal, an ion, an oxide, a metal salt, a complex, or the like. In general, the valence of Mn may be 4+, 2+, or 3+. The reason for this is as described below. When a conduction electron is present in a crystal (e.g., when an oxygen defect is present in the crystal or when the A site is occupied by a donor element), the valence of Mn is decreased from 4+ to 3+, 2+, or the like, and thus the conduction electron is trapped, with the result that insulation resistance can be improved.

Meanwhile, when the valence of Mn is less than 4+ such as 2+, Mn serves as an acceptor. When Mn is present as an acceptor in a perovskite-type single crystal, holes are generated in the crystal or oxygen vacancies are formed in the single crystal.

When the valence of Mn in a sample is 2+ or 3+, the holes cannot be fully compensated merely by the introduction of the oxygen vacancies, and hence the insulation resistance is decreased. Accordingly, most of Mn preferably has a valence of 4+. However, a significantly small amount of Mn may have a valence of less than 4+ and occupy the B site of the perovskite structure as an acceptor to form oxygen vacancies. Mn having a valence of 2+ or 3+ and the oxygen vacancies form defect dipoles, and hence an internal electric field is generated. The direction of the internal electric field can be aligned with spontaneous polarization by polarization treatment, and the alignment can contribute to a substantial increase in coercive electric field.

In addition, when the content of Bi in the single crystal of the present invention is 0.0005 part by mole or more to 0.0060 part by mole or less with respect to 1 part by mole of the metal oxide, trivalent Bi can occupy the A site. Accordingly, Mn at the B site easily has a valence of less than 4+ in order to achieve charge balance, and hence can serve as an acceptor.

The valence of Mn in the single crystal of the present invention may be evaluated by measuring the temperature dependence of magnetic susceptibility. The magnetic susceptibility may be measured with a superconducting quantum interference device (SQUID), a vibrating-sample magnetometer (VSM), or a magnetic balance. The magnetic susceptibility χ obtained by the measurement generally follows the Curie-Weiss law represented by Equation 4. $χ = C / \left(T-θ\right) \left(C:Curie constant,θ:paramagnetic Curie temperature\right)$ (4)

In general, Mn added in a slight amount to a non-magnetic material shows a spin S of 5/2 when having a valence of 2+, a spin S of 2 when having a valence of 3+, and a spin S of 3/2 when having a valence of 4+. Accordingly, the Curie constant C converted per unit Mn amount becomes a value corresponding to the value of the spin S at each valence of Mn. Thus, the average valence of Mn in the sample can be evaluated by deriving the Curie constant C from the temperature dependence of the magnetic susceptibility χ.

When the content of Mn is less than 0.0020 part by mole, the coercive electric field becomes small at less than 1.2 kV/cm at room temperature of 25°C. When the coercive electric field is small, there is a limit to an applied voltage for driving the piezoelectric element, and hence a large vibration cannot be obtained. In the present invention, the coercive electric field Ec is preferably 4.0 kV/cm or more, more preferably 6.0 kV/cm or more. The coercive electric field Ec is still more preferably 8.0 kV/cm or more. The coercive electric field Ec is particularly preferably 10 kV/cm or more.

Meanwhile, when the content of Mn is more than 0.0500 part by mole, the insulation property of the piezoelectric element rather deteriorates. For example, the dielectric loss tangent of the single crystal at a frequency of 1 kHz may exceed 0.01, or the resistivity thereof may fall below 1 GΩcm. The dielectric loss tangent may be measured with an impedance analyzer.

When the dielectric loss tangent is 0.01 or less, a stable operation can be obtained even when the single crystal is used as a piezoelectric element and a high voltage is applied thereto. When the resistivity of the single crystal is 1 GΩcm, polarization can be performed, and hence the single crystal can be driven as a piezoelectric element. The resistivity is more preferably 50 GΩcm or more.

### (Configuration of Piezoelectric Element)

The piezoelectric element of the present invention includes a single crystal of a perovskite-type metal oxide and electrodes facing each other. Fig. 1 is a schematic view for illustrating the configuration of a piezoelectric element according to one embodiment of the present invention. The piezoelectric element according to the present invention is a piezoelectric element including at least a first electrode 11, a single crystal 3, and a second electrode 33, and its piezoelectric constant may be evaluated. The first electrode 11 and the second electrode 33 are each formed of a conductive layer having a thickness of from about 5 nm to about 10 µm. A material therefor is not particularly limited, and is only required to be a material to be generally used for a piezoelectric element. Examples thereof may include metals, such as Ti, Pt, Ta, Ir, Sr, In, Sn, Au, Al, Fe, Cr, Ni, Pd, Ag, and Cu, alloys, and compounds thereof.

### (Crystal Orientation: Relationship between Easy Polarization Axis and Piezoelectricity)

In the piezoelectric element, when an environmental temperature is 25°C, the crystal system of the single crystal is a tetragonal system, and the crystal orientation of a surface of the single crystal in contact with each of electrode surfaces of the electrodes facing each other (the respective electrode surfaces of the first electrode 11 and the second electrode 33) is (110) or (111). In the piezoelectric element of the present invention, the crystal orientation of the surface of the single crystal in contact with each of the electrode surfaces facing each other is preferably (110), and when the electrode surfaces of the electrodes facing each other are set as main surfaces of the piezoelectric element, the crystal orientation of the side surface of the piezoelectric element on the longitudinal direction side of the electrode surfaces is preferably (001).

When a voltage is applied to the piezoelectric element of the tetragonal system single crystal having a crystal orientation of (110) in the direction of the electrodes facing each other to perform the polarization treatment, its polarization axes become two directions of [100] and [010].

When a voltage is applied to the piezoelectric element of the tetragonal system single crystal having a crystal orientation of (111) in the direction of the electrodes facing each other to perform the polarization treatment, its polarization axes become three directions of [100], [010], and [001].

When a voltage is applied to the piezoelectric element of the tetragonal system single crystal having a crystal orientation of (100) in the direction of the electrodes facing each other to perform the polarization treatment, its polarization axis becomes only one direction of [001].

In the present invention, the polarization axes are in a plurality of directions, and hence a plurality of domains can exist at high density, and large piezoelectric characteristics can be obtained.

### <<Second Embodiment>>

A second embodiment relates to a method of producing a piezoelectric element.

A method of producing a piezoelectric element of the present invention is a method of producing a piezoelectric element, the method including:
a first preparation step of preparing a matrix and a seed single crystal;
a second preparation step of preparing an integrated body in which a surface of the matrix and a (110) plane or a (111) plane of the seed single crystal are arranged in contact with each other;
a first temperature-increasing step of increasing a temperature of the integrated body from room temperature to a liquid-phase start temperature of the matrix;
a second temperature-increasing step of increasing the temperature of the integrated body from the liquid-phase start temperature to a liquid-phase end temperature of the matrix;
a heating step of heating the integrated body at the liquid-phase end temperature;
a step of obtaining a single crystal from the integrated body after the heating;
a step of arranging electrodes facing each other on the single crystal to produce a piezoelectric element; and
a step of subjecting the piezoelectric element to polarization treatment,
wherein a rate of temperature increase in the second temperature-increasing step is lower than a rate of temperature increase in the first temperature-increasing step.

The respective steps are described below.

### (Raw Material for Piezoelectric Material)

When the single crystal of the present invention is to be produced, a general method including producing a compact from solid powder, such as an oxide, a carbonate, a nitrate, an oxalate, or an acetate, containing constituent elements, and sintering the compact under normal pressure may be adopted. A raw material therefor includes a compound, such as a Ba compound, a Ti compound, a Zr compound, or a Mn compound.

Examples of the Ba compound that may be used include barium oxide, barium carbonate, barium oxalate, barium acetate, barium nitrate, barium titanate, and barium zirconate. A commercially available high-purity type (e.g., a purity of 99.99% or more) compound is preferably used as such Ba compound.

Examples of the Ti compound that may be used include titanium oxide, barium titanate, and barium zirconate titanate. When such Ti compound contains an alkaline earth metal such as barium, a commercially available high-purity type (e.g., a purity of 99.99% or more) compound is preferably used.

Nb in such an amount to be incorporated as an unavoidable component in a commercially available raw material for Ti, and Hf in such an amount to be incorporated as an unavoidable component in a commercially available raw material for Zr may be incorporated.

Examples of the Zr compound that may be used include zirconium oxide, barium zirconate, and barium zirconate titanate. When such Zr compound contains an alkaline earth metal such as barium, a commercially available high-purity type (e.g., a purity of 99.99% or more) compound is preferably used.

Examples of the Mn compound that may be used include manganese carbonate, manganese oxide, manganese dioxide, manganese acetate, and trimanganese tetraoxide.

In addition, a raw material for adjusting α, which represents the ratio of the presence amount of Ba at the A site to the molar amount of Ti and Zr at the B site in the piezoelectric material according to the present invention, is not particularly limited. The effect is the same for any of a Ba compound, a Ti compound, and a Zr compound.

### (Relative Density)

The relative density of the single crystal that is a piezoelectric body to be used in the piezoelectric element of the present invention is preferably 93% or more to 100% or less. When the relative density is less than 93%, the mechanical strength may decrease. The relative density of the piezoelectric material of the present invention more preferably falls within the range of 95% or more to 100% or less. The relative density still more preferably falls within the range of 97% or more to 100% or less. When the relative density is 95% or more, damage during processing is less liable to occur, and when the relative density is 97% or more, chipping during cutting and polishing is reduced.

In the piezoelectric element of the present invention, it is preferred that the single crystal contain less than 1,000 ppm of Pb. With such configuration, the piezoelectric element can reduce an environmental load. The content of Pb in the single crystal may be determined by measurement by ICP emission spectrometry.

### (Method of producing Single Crystal by Solid Phase Epitaxy)

A specific method of producing the single crystal to be used in the piezoelectric element of the present invention is described below.

Fig. 8A and Fig. 8B are each a schematic view for illustrating an integrated body of a seed single crystal and a matrix in one embodiment of the present invention.

In Fig. 8A, a seed single crystal 2 is arranged on the upper portion of a matrix 1 to form an integrated body in which the surface of the matrix 1 and the surface of the seed single crystal 2 are arranged in contact with each other.

The method of producing a single crystal of a perovskite-type oxide of the present invention is, for example, a method of producing a perovskite-type single crystal by heating the matrix 1 as illustrated in Fig. 8B.

### <First Preparation Step>

The method of producing a piezoelectric element of the present invention includes a first preparation step of preparing the matrix and the seed single crystal.

The seed single crystal 2 used in the method of producing a perovskite-type single crystal of the present invention may be a bulk or a thin film, but is preferably a bulk having a thickness of 10 µm or more in terms of high strength because stress due to a mismatch in lattice constant and a difference in thermal expansion between the seed single crystal 2 and the matrix 1 may be generated in the seed single crystal 2 to cause damage in a region in contact with the matrix 1. In addition, it is preferred that the matrix 1 and the seed single crystal 2 have substantially the same composition.

The seed single crystal 2 may be selected and prepared from commercially available oxide single crystals, semiconductor single crystals, fluoride/alkali halide single crystals, metal single crystals, alloy single crystals, and the like, but a perovskite-type single crystal is preferred because the stress due to the mismatch in lattice constant and the difference in thermal expansion between the seed single crystal 2 and the matrix 1 is less liable to be generated.

Examples of the perovskite-type single crystal used as the seed single crystal 2 include BaTiO₃, BaZrO₃, SrTiO₃, CaTiO₃, Pb(Mg_{1/3}Nb_{2/3})O₃, KTaO₃, KNbO₃, SrRuO₃, LiNbO₃, LaNiO₃, AgNbO₃, CdTiO₃, and solid solutions thereof.

In addition, a single crystal obtained by the production method of the present invention may be used as the seed single crystal 2 used in the production method of the present invention.

### (Description of Matrix)

The matrix 1 of the present invention is a compact or a sintered body. The shape of the matrix 1 is not particularly limited, but a shape having a flat surface, such as a rectangular parallelepiped shape or a disc shape, is preferred because the matrix 1 is easy to arrange in contact with the seed single crystal 2.

A step of preparing the matrix is described below.

### (Raw Material Powder for producing Matrix)

A raw material used for the matrix 1 of the present invention is solid powder, such as an oxide, a carbonate, a nitrate, or an oxalate, containing constituent elements for forming the single crystal of the present invention, or mixed powder thereof.

In this case, when the main component of the single crystal is not a lead-based material, it is more preferred that the content of lead (Pb) in the raw material be less than 1,000 ppm because the environmental load is small.

Preferred examples of elements for forming the raw material include Li, Na, Mg, Al, Si, K, Ca, Sc, Ti, V, Cr, Mn, Fe, Co, Zn, Ge, Sr, Y, Zr, Nb, Mo, Sn, Sb, Ba, Hf, Ta, Bi, La, Nd, Sm, Eu, Gd, Tb, Dy, Ho, Er, and Yb.

The raw material may have been subjected to heat treatment for the purpose of homogenization, and may have been crushed after the heat treatment. The heat treatment for homogenizing the raw material is preferably performed within the range of 800°C or more to 1,300°C or less because the raw material is easy to crush after the heat treatment.

### (Growth Promoter for promoting Single Crystallization of Matrix)

A compound for promoting single crystallization by a solid phase epitaxy method may be added to the matrix 1 of the present invention in addition to the solid powder containing the constituent elements for forming the single crystal, or the mixed powder thereof. Examples of the promoting compound include lithium carbonate, silicon oxide, and aluminum oxide, and it is preferred to add 3 parts by mole to 7 parts by mole of lithium carbonate to 1 mol of the perovskite-type metal oxide serving as the main component of the matrix 1.

### (Granulation of Raw Material for producing Matrix)

The raw material for the matrix 1 used in the method of producing a single crystal of the present invention may be granulated, and a granulation method therefor is not particularly limited. Examples of a binder that may be used during the granulation include polyvinyl alcohol (PVA), polyvinyl butyral (PVB), and an acrylic resin. The amount of the binder to be added to the above-mentioned mixed powder is preferably from 1 part by weight to 10 parts by weight, more preferably from 2 parts by weight to 5 parts by weight from the viewpoint of increasing the density of the compact. The granulation method is most preferably a spray-drying method from the viewpoint that the grain diameter of the granulated powder can be made more uniform.

### (Compact of Raw Material for producing Matrix)

The compact of the matrix 1 used in the method of producing a single crystal of the present invention is a compact obtained by compacting the above-mentioned raw material into a desired shape, and a production method therefor is not particularly limited. The compact is a solid produced from raw material powder, granulated powder (binder), or slurry.

Uniaxial pressing, cold isostatic pressing, hot isostatic pressing, slip casting, extrusion molding, or the like may be used as means for producing the compact. In addition, the raw material in a slurry state may be formed into a sheet shape by using a doctor blade method and dried, and the sheets may be stacked to be molded into a target shape. When the sheet is subjected to a deaeration step before drying, its density increases so that the density of the matrix 1 using the sheet also increases, and hence the density of the single crystal produced by using the matrix 1 also increases, which is preferred.

It is preferred that the matrix 1 in the method of producing a single crystal of the present invention be a compact. Also in this case, as illustrated in Fig. 8A, it is only required that the seed single crystal 2 be placed on the matrix 1, and the matrix 1 and the seed single crystal 2 be arranged in contact with each other. When heat treatment is performed under such state, the matrix 1 shrinks and the seed single crystal 2 slightly bites into the matrix 1 so that the matrix 1 and the seed single crystal 2 are brought into closer contact. That is, the contact area between the matrix 1 and the seed single crystal 2 increases.

There is a method of putting the seed single crystal 2 into the compact at the time of molding, but there is a risk of large deformation, breakage, or a crack due to a difference in shrinkage amount between the compact and the seed single crystal 2 during heat treatment. Accordingly, when the matrix 1 is a compact, it is preferred that the seed single crystal 2 be arranged in contact with each surface of the matrix 1.

When the seed single crystal 2 is arranged, it is required to match the crystal orientation of a surface where the seed single crystal 2 is in contact with the matrix 1 with a desired crystal orientation of the single crystal in advance. For this purpose, the seed single crystal 2 is oriented by the pole figure of X-ray diffraction or the Laue method, and is polished in a desired orientation to expose a surface, and the surface is used as the surface where the seed single crystal is in contact with the matrix.

It is preferred that the matrix 1 and the seed single crystal 2 be arranged vertically so as to be in contact with each other. Further, it is preferred to place a weight on the matrix 1 and the seed single crystal 2 because the matrix 1 and the seed single crystal 2 are likely to be brought into contact with each other. Even when a force in a direction in which the matrix 1 and the seed single crystal 2 are separated from each other acts owing to deformation during heat treatment, a force in a direction of suppressing the above-mentioned force acts owing to the weight so that the matrix 1 and the seed single crystal 2 are more likely to be brought into contact with each other.

It is preferred that the area of the surface of the seed single crystal 2 on the side in contact with the matrix 1 be equal to or less than the area of the surface of the matrix 1 on the side in contact with the seed single crystal 2. The portion of the seed single crystal 2 larger than the matrix 1 does not contribute to the single crystallization of the matrix 1, and is hence wasted. However, when the seed single crystal 2 is excessively small, the heat treatment time for expanding the single crystal region to the entire matrix becomes long. Accordingly, it is preferred that the area of the surface of the seed single crystal 2 on the side in contact with the matrix 1 be 50% or more to 100% or less of the area of the surface of the matrix 1 on the side in contact with the seed single crystal 2.

### (Sintering)

When the matrix 1 is used as a sintered body, the above-mentioned compact may be sintered, and means for the sintering is not limited. Examples of the sintering method include sintering using an electric furnace, sintering using a gas furnace, a hot pressing method, a conduction heating method, a microwave sintering method, a millimeter-wave sintering method, hot isostatic pressing (HIP), and a flash sintering method. A hot pressing method, a conduction heating method, HIP, or the like, which involves high pressure at high temperature, is preferred because voids in the matrix can be reduced in size or number. When the volume of voids in the matrix is small, the density of the single crystal obtained from the matrix 1 becomes large, which is preferred.

It is preferred that the relative density of the matrix 1 be 93% or more to 100% or less. When the relative density of the matrix 1 is 93% or more to 100% or less, the density of the single crystal obtained from the matrix 1 also becomes large.

The relative density is the ratio of a measured density to a theoretical density calculated from the lattice constant of the piezoelectric material and the atomic weight of the constituent elements of the piezoelectric material. The lattice constant may be measured, for example, by X-ray diffraction analysis. The density may be measured, for example, by the Archimedes method.

When the ratio of the measured density (ρmeas.) to the theoretical density (ρcalc.) obtained from the composition and lattice constant of the sintered body, that is, the relative density (ρcalc./ρmeas.), is 93% or more, it can be said that the relative density is sufficiently high.

### (Crystal Orientation Alignment)

The single crystal obtained by the sintering as described above is subjected to a step of measuring a crystal orientation by the pole figure of X-ray diffraction or the Laue method, and then its front and back surfaces are each polished so as to have a desired orientation.

Examples of a polishing method include mechanical polishing, chemical polishing, and CMP polishing, and those methods may be used in combination for polishing.

The mechanical polishing refers to polishing performed by using a machine, and in the case of performing the mechanical polishing, the machine may be selected and used from a polisher, a lapping machine, a polishing machine, and a buffing machine. In addition, a step using a precision grinding machine or the like using a fine grindstone may also be a polishing step.

The chemical polishing is a polishing method in which a sample is immersed in a polishing solution and the surface of the sample is corroded by the chemical reaction by the action of an acid or an alkali. For example, there is a method of performing polishing by a rotary type in which a polishing pad is attached onto a disc-shaped surface plate, a polishing material of a liquid containing a chemical component and fine particles is dropped thereon, and polishing is performed while the disc-shaped surface plate is rotated.

The CMP polishing is a method including a combination of mechanical polishing and chemical polishing, in which, in addition to the mechanical action of abrasive grains scraping the surface of a sample, a chemical action occurs between the abrasive grains and the sample or with a polishing liquid or a grinding liquid, and the surface is planarized by the physical polishing and the chemical reaction.

A mirror surface may be produced by the chemical polishing or the CMP polishing.

When the matrix 1 is prepared as a sintered body, it is preferred to sinter the matrix 1 at the temperature at which the crystal grains do not become excessively large during sintering. A method of performing sintering in the atmosphere during heating set to a reducing atmosphere, such as nitrogen or argon, may be used as means for preventing an increase in size of the crystal grains. When the matrix 1 is used as a sintered body, the grain diameters of the crystal grains of the matrix 1 are each preferably 50 µm or less, more preferably 10 µm or less.

The "grain diameter" as used herein represents a "projected area equivalent circle diameter" generally referred to in a microscopic observation method, and represents the diameter of a perfect circle having the same area as that of the projected area of the crystal grain. In the present invention, a method of measuring the grain diameter is not particularly limited. For example, the grain diameter may be determined by subjecting a photographic image, which is obtained by photographing the surface of a sample with a polarizing microscope or a scanning electron microscope, to image processing. The optimum magnification varies depending on a target grain diameter, and hence an optical microscope and an electron microscope may be used properly depending on the case. The equivalent circle diameter may be determined from an image of a polished surface or a cross section instead of the surface of the sample.

### <Second Preparation Step>

The method of producing a piezoelectric element of the present invention includes a second preparation step of preparing an integrated body in which the surface of the matrix and the (110) plane or (111) plane of the seed single crystal are arranged in contact with each other.

### (Heating Method)

A method of heating the integrated body of the matrix 1 and the seed single crystal 2 is not particularly limited, but sintering using an electric furnace is preferred because a large number of integrated bodies can be heated at once so that production costs can be suppressed.

### (Saggar, Setter, Beads, Weight)

Fig. 8A, Fig. 8B, Fig. 9, and Fig. 10 are examples of schematic views for illustrating the configuration for producing a single crystal of the present invention. In Fig. 8B, a weight 4 is placed on an integrated body of the matrix 1 and the seed single crystal 2, and the integrated body is arranged on a setter 6 via beads 5. Fig. 9 is an illustration of those components placed in a saggar 7, and Fig. 10 is an illustration of the saggar 7 of Fig. 9 covered with a lid 8, and the saggar 7 covered with the lid 8 is placed in an electric furnace and heated.

When the matrix 1 is to be heated, it is preferred to put the matrix 1 and the seed single crystal 2 in the saggar 7 for heat treatment, and the saggar 7 is preferably a box shape with a lid because the matrix 1 and the seed single crystal 2 are less susceptible to the influence of, for example, furnace contamination.

The matrix 1 and the seed single crystal 2 are preferably placed on the setter 6 that does not easily react with the matrix 1 or the seed single crystal 2 to be subjected to the heat treatment. As a material for the setter 6, for example, alumina, zirconia, alumina coated with zirconia on the surface, stabilized zirconia, silicon carbide, or silicon nitride may be used. The beads 5 such as stabilized zirconia, powder obtained by sintering and pulverizing the matrix 1 at high temperature, a platinum sheet, or the like may be placed on the setter 6, and the matrix 1 and the seed single crystal 2 may be placed thereon. When it is difficult to determine whether or not it is difficult to react, it is sufficient to actually try each material and select the material with the least traces left after heating.

There is a method of putting the seed single crystal 2 into the compact at the time of molding, but there is a risk of large deformation, breakage, or a crack due to a difference in shrinkage amount between the compact and the seed single crystal 2 during heat treatment. Accordingly, when the matrix 1 is a compact, it is preferred that the seed single crystal 2 be arranged in contact with each surface of the matrix 1.

When the seed single crystal is arranged, it is required to match the crystal orientation of a surface where the seed single crystal is in contact with the matrix with a desired crystal orientation of the single crystal in advance. For this purpose, the seed single crystal is oriented by the pole figure of X-ray diffraction or the Laue method, and is polished in a desired orientation to expose a surface, and the surface is used as the surface where the seed single crystal is in contact with the matrix.

It is preferred that the matrix 1 and the seed single crystal 2 be arranged vertically so as to be in contact with each other. Further, it is preferred to place a weight on the matrix 1 and the seed single crystal 2 because the matrix 1 and the seed single crystal 2 are likely to be brought into contact with each other. Even when a force in a direction in which the matrix 1 and the seed single crystal 2 are separated from each other acts owing to deformation during heat treatment, a force in a direction of suppressing the above-mentioned force acts owing to the weight so that the matrix 1 and the seed single crystal 2 are more likely to be brought into contact with each other.

It is preferred that the area of the surface of the seed single crystal 2 on the side in contact with the matrix 1 be equal to or less than the area of the surface of the matrix 1 on the side in contact with the seed single crystal 2. The portion of the seed single crystal 2 larger than the matrix 1 does not contribute to the single crystallization of the matrix 1, and is hence wasted. However, when the seed single crystal 2 is excessively small, the heat treatment time for expanding the single crystal region to the entire matrix becomes long. Accordingly, it is preferred that the area of the surface of the seed single crystal 2 on the side in contact with the matrix 1 be 50% or more to 100% or less of the area of the surface of the matrix 1 on the side in contact with the seed single crystal 2.

### <First Temperature-increasing Step>

The method of producing a piezoelectric element of the present invention includes a first temperature-increasing step of increasing the temperature of the integrated body from room temperature to the liquid-phase start temperature of the matrix.

In the first temperature-increasing step of increasing the temperature to the liquid-phase start temperature, substantially uniform crystal grain growth is performed in the matrix. As described above, when the crystal grains of the matrix 1 become excessively large, it becomes difficult for the matrix 1 to be incorporated into the single crystal. Thus, it is preferred to perform the first temperature-increasing step in a short time so that the crystal grains do not become excessively large.

### <Second Temperature-increasing Step>

The method of producing a piezoelectric element of the present invention includes a second temperature-increasing step of increasing the temperature of the integrated body from the liquid-phase start temperature to the liquid-phase end temperature of the matrix. In addition, in the method of producing a piezoelectric element of the present invention, the rate of temperature increase in the second temperature-increasing step is lower than the rate of temperature increase in the first temperature-increasing step.

In the second temperature-increasing step, the interface between the seed single crystal 2 and the matrix 1 becomes a liquid phase, and the single crystal interface expands toward the matrix 1 side. However, in the case of composition that differs in temperature depending on the location owing to a difference in orientation between the crystal grains of the matrix 1 in contact with the seed single crystal 2, the interfaces of the crystal grains of different orientations in the matrix 1 also expand at the same time, and hence a single crystal that is a single crystal grain is not obtained in some cases.

Accordingly, when the rate of temperature increase from the liquid-phase start temperature to the liquid-phase end temperature in the second temperature-increasing step is made lower than the rate of temperature increase from room temperature to the liquid-phase start temperature in the first temperature-increasing step, a single crystal formed of a single crystal grain can be grown from the seed single crystal 2.

When the single crystal is kept at the liquid-phase end temperature after the temperature increase, the single crystal grown from the seed single crystal 2 can be further enlarged.

### <Heating Step>

The method of producing a piezoelectric element of the present invention includes a heating step of heating the integrated body at the liquid-phase end temperature.

In this case, when the atmosphere during the heating contains oxygen, the liquid phase is more likely to spread so that a larger single crystal can be produced more quickly. Accordingly, it is preferred that the atmosphere during the heating contain oxygen.

### <Step of obtaining Single Crystal>

Next, a step of obtaining a perovskite-type single crystal from the heated matrix 1 after the second temperature-increasing step is described.

The method of producing a piezoelectric element of the present invention includes a step of obtaining a single crystal from the integrated body after the heating.

After the second temperature-increasing step, which region in the matrix is a single crystal may be determined by whether there is a grain boundary with a microscope. When there is no grain boundary, the region is a single crystal formed of a single crystal grain. In addition, the determination may be made by using structural analysis by X-ray diffraction or electron beam diffraction.

When the polycrystalline portion and the seed single crystal 2 portion other than the single crystal region are removed by a wire saw, a dicing saw, water jet cutting, electric discharge machining, laser processing, polishing, or the like, only the single crystal region can be obtained.

Also when the integrated body is kept at the liquid-phase end temperature for a certain period of time after the second temperature-increasing step, a single crystal can be obtained from the matrix 1 by the same method.

### <Step of producing Piezoelectric Element>

The method of producing a piezoelectric element of the present invention includes a step of arranging electrodes facing each other on the single crystal to produce a piezoelectric element.

Fig. 1 is a schematic view for illustrating the configuration of a piezoelectric element according to one embodiment of the present invention. The piezoelectric element according to the present invention is a piezoelectric element including at least the first electrode 11, the single crystal 3, and the second electrode 33, and its piezoelectric constant may be evaluated. The first electrode 11 and the second electrode 33 are each formed of a conductive layer having a thickness of from about 5 nm to about 10 µm. A material therefor is not particularly limited, and is only required to be a material to be generally used for a piezoelectric element. Examples thereof may include metals, such as Ti, Pt, Ta, Ir, Sr, In, Sn, Au, Al, Fe, Cr, Ni, Pd, Ag, and Cu, alloys, and compounds thereof.

Each of the first electrode 11 and the second electrode 33 may be formed of one kind of those materials, or may be obtained by stacking two or more kinds thereof. In addition, the first electrode 11 and the second electrode 33 may be formed of materials different from each other.

A method of producing each of the first electrode 11 and the second electrode 33 is not limited. Those electrodes may each be formed by baking a metal paste or by sputtering, vapor deposition, or the like. In addition, both the first electrode 11 and the second electrode 33 may be used by being patterned in desired shapes.

### <Step of performing Polarization Treatment>

The method of producing a piezoelectric element of the present invention includes a step of subjecting the piezoelectric element to polarization treatment.

It is more preferred that the piezoelectric element have polarization axes aligned in a certain direction. When the polarization axes are aligned in a certain direction, the piezoelectric constant of the piezoelectric element is increased.

A method of polarizing the piezoelectric element is not particularly limited. The polarization treatment may be performed in the air or in silicone oil. The temperature during the polarization is preferably the temperature at which the single crystal undergoes phase transition. For example, a temperature of from 60°C to 150°C is preferred, but the optimum conditions slightly differ depending on the composition of the single crystal for forming the element. An electric field applied for performing the polarization treatment is preferably from 8 kV/cm to 20 kV/cm, and it is preferred to decrease the environmental temperature to the temperature at which the single crystal has the same crystal structure as that at room temperature, and then to terminate the application of the electric field, in order to obtain a satisfactory piezoelectric constant.

### <<Evaluation Method>>

Some of evaluation methods in the present invention are described below.

### (Evaluation of Crystal Orientation)

A crystal orientation may be evaluated by X-ray diffraction. For example, whether a desired crystal orientation is aligned with a measurement surface or how many degrees the orientation is tilted may be evaluated by pole figure measurement. An inclination between the desired orientation and the orientation of the measurement surface is preferably 2° or less. When the inclination is 2° or less, influences on the electromechanical coupling coefficient and the coercive electric field are small. When the inclination is more than 2°, the electromechanical coupling coefficient and the coercive electric field sharply decrease. The inclination between the desired orientation and the orientation of the measurement surface is more preferably 1° or less. When the inclination is 1° or less, an electromechanical coupling coefficient and a coercive electric field with higher reproducibility can be obtained.

### (Measurement of Phase Transition Temperature)

The phase transition temperature Tot between a tetragonal system and an orthorhombic system of the piezoelectric element was set as the temperature at which a dielectric constant took the maximum value, which appeared at a temperature lower than a Curie temperature Tc when a measurement temperature is increased from a low temperature to the Curie temperature Tc or higher through use of a k₃₁ element.

### (Measurement of Electromechanical Coupling Coefficient)

In order to measure the electromechanical coupling coefficient of the piezoelectric element, first, measurement results of a resonance frequency and an antiresonance frequency are obtained through use of a commercially available impedance analyzer (4294A manufactured by Agilent Technologies). Then, through use of the measurement results, the coefficient may be determined by calculation based on the Japan Electronics and Information Technology Industries Association standards (JEITA EM-4501). The method is hereinafter referred to as "resonance-antiresonance method."

The electromechanical coupling coefficient of the piezoelectric element of the present invention is preferably 30% or more for k₃₁.

When the electromechanical coupling coefficient of the piezoelectric element is 30% or more for k₃₁, a piezoelectric element with small power consumption is achieved because driving efficiency is high for a device using a bending mode such as an ultrasonic motor.

The electromechanical coupling coefficient of the piezoelectric element of the present invention is preferably 67% or more for k₃₃.

When the electromechanical coupling coefficient of the piezoelectric element is 67% or more for k₃₃, a piezoelectric element with small power consumption is achieved because driving efficiency is high for a device using a longitudinal vibration mode such as an ultrasonic probe.

The electromechanical coupling coefficient of the piezoelectric element of the present invention is preferably 62% or more for k'₃₃.

When the electromechanical coupling coefficient of the piezoelectric element is 62% or more for k'₃₃, a piezoelectric element with small power consumption is achieved because driving efficiency is high for a device using a longitudinal vibration mode such as an ultrasonic probe similarly to k₃₃.

### (Evaluation of PE Hysteresis and Coercive Field)

A ferroelectric/piezoelectric evaluation system (LC II manufactured by Radiant Technologies, Inc.) may be used for the evaluation of a coercive electric field. In a hysteresis measurement mode, an electric field at the time of a polarization amount of 0 was read from a PE hysteresis curve obtained from a polarization amount with respect to an electric field, and the value was defined as a coercive electric field.

### (Piezoelectric Element Figure of Merit)

A product (k'₃₃×Ec) of the electromechanical coupling coefficient k'₃₃ and the coercive electric field Ec was used as a figure of merit indicating that the piezoelectric element of the present invention achieves both of low power consumption based on high driving efficiency and large amplitude performance. It is preferred that k'₃₃×Ec be more than 200 for a piezoelectric element exhibiting low power consumption and large amplitude performance. k'3_{3×}Ec is more preferably 360.

### <<Application Examples>>

Application examples of the present invention include an ultrasonic motor, an optical apparatus, a vibration device, a dust removing device, an image pickup apparatus, an ultrasonic probe, an ultrasonic diagnostic apparatus, an ultrasonic diagnostic system, and an electronic apparatus. Those applications are described below.

### (Ultrasonic Motor)

The ultrasonic motor of the present invention includes at least: a vibrating body including the above-mentioned piezoelectric element; and a moving body to be brought into contact with the vibrating body. Fig. 11 is a schematic view for illustrating the configuration of an ultrasonic motor according to one embodiment of the present invention. Fig. 11 is an illustration of an ultrasonic motor in which the piezoelectric element of the present invention is formed of a single plate.

The ultrasonic motor includes: a vibrator 201; a rotor 202 that is in contact with the sliding surface of the vibrator 201 with a pressing force by a pressure spring (not shown); and an output shaft 203 provided integrally with the rotor 202. The vibrator 201 includes: a metal elastic ring 2011; a piezoelectric element 2012 of the present invention; and an organic adhesive 2013 for bonding the piezoelectric element 2012 to the elastic ring 2011 (such as an epoxy- or cyanoacrylate-based adhesive). The piezoelectric element 2012 of the present invention includes a single crystal sandwiched between the first electrode 11 (not shown) and the second electrode 33 (not shown).

The application of two AC voltages different from each other in phase by an odd multiple of π/2 to the piezoelectric element of the present invention results in the generation of a flexural traveling wave in the vibrator 201, and hence each point on the sliding surface of the vibrator 201 undergoes an elliptical motion. When the rotor 202 is brought into press contact with the sliding surface of the vibrator 201, the rotor 202 receives a frictional force from the vibrator 201 to rotate in a direction opposite to a flexural traveling wave. A body to be driven (not shown) is joined to the output shaft 203, and is driven by the rotary force of the rotor 202.

When a voltage is applied to the single crystal, the single crystal expands and contracts by a transverse piezoelectric effect. The conversion efficiency from the electrical energy to the mechanical energy depends on the magnitude of the electromechanical coupling coefficient. When an elastic body such as a metal is bonded to a piezoelectric element by an adhesive or the like, the elastic body is bent by the expansion and contraction of the single crystal via the adhesive. The ultrasonic motor of the kind described in the foregoing utilizes this principle.

### (Optical Apparatus)

Next, an optical apparatus of the present invention is described. The optical apparatus of the present invention includes a drive unit including the ultrasonic motor.

Fig. 12A and Fig. 12B are each a sectional view of main parts of an interchangeable lens barrel for a single-lens reflex camera as an example of an optical apparatus according to an exemplary embodiment of the present invention. In addition, Fig. 13 is an exploded perspective view of the interchangeable lens barrel for the single-lens reflex camera as the example of the optical apparatus according to the exemplary embodiment of the present invention. A fixed barrel 712, a linear guide barrel 713, and a front group barrel 714 capable of accommodating a front group lens 701 are fixed to an attaching/detaching mount 711 for a camera. Those members are fixed members of the interchangeable lens barrel.

A linear guide groove 713a in an optical axis direction for a focus lens 702 is formed on the linear guide barrel 713. Cam rollers 717a and 717b protruding outward in a radial direction are fixed to a rear group barrel 716 holding the focus lens 702 via axial screws 718, and the cam roller 717a is fitted in the linear guide groove 713a.

A cam ring 715 is fitted on the inner periphery of the linear guide barrel 713 in a rotatable manner. Relative movement between the linear guide barrel 713 and the cam ring 715 in the optical axis direction is restricted because a roller 719 fixed to the cam ring 715 is fitted in an annular groove 713b of the linear guide barrel 713. A cam groove 715a for the focus lens 702 is formed on the cam ring 715, and the above-mentioned cam roller 717b is simultaneously fitted in the cam groove 715a.

On the outer peripheral side of the fixed barrel 712, there is arranged a rotation transmission ring 720 held by a ball race 727 in a rotatable manner at a constant position with respect to the fixed barrel 712. The rotation transmission ring 720 has shafts 720f extending radially from the rotation transmission ring 720, and rollers 722 are held by the shafts 720f in a rotatable manner. A large diameter part 722a of the roller 722 is brought into contact with a mount side end surface 724b of a manual focus ring 724. In addition, a small diameter part 722b of the roller 722 is brought into contact with a joining member 729. Six rollers 722 are arranged on the outer periphery of the rotation transmission ring 720 at regular intervals, and each roller is arranged in the relationship as described above.

A low friction sheet (washer member) 733 is arranged on the inner diameter part of the manual focus ring 724, and the low friction sheet 733 is sandwiched between a mount side end surface 712a of the fixed barrel 712 and a front side end surface 724a of the manual focus ring 724. In addition, the outer diameter surface of the low friction sheet 733 is formed in a ring shape so as to be radially fitted to an inner diameter part 724c of the manual focus ring 724. Further, the inner diameter part 724c of the manual focus ring 724 is radially fitted to an outer diameter part 712b of the fixed barrel 712. The low friction sheet 733 has a role of reducing friction in a rotation ring mechanism in which the manual focus ring 724 rotates relatively to the fixed barrel 712 about the optical axis.

The large diameter part 722a of the roller 722 is brought into contact with the mount side end surface 724b of the manual focus ring 724 under a state in which a pressure is applied by a pressing force of a waved washer 726 pressing an ultrasonic motor 725 to the front of the lens. In addition, similarly, the small diameter part 722b of the roller 722 is brought into contact with the joining member 729 under a state in which an appropriate pressure is applied by a pressing force of the waved washer 726 pressing the ultrasonic motor 725 to the front of the lens.

The movement of the waved washer 726 in the mount direction is restricted by a washer 732 connected to the fixed barrel 712 by bayonet joint. A spring force (biasing force) generated by the waved washer 726 is transmitted to the ultrasonic motor 725, and further to the roller 722, to be a force for the manual focus ring 724 to press the mount side end surface 712a of the fixed barrel 712. In other words, the manual focus ring 724 is integrated under a state in which the manual focus ring 724 is pressed to the mount side end surface 712a of the fixed barrel 712 via the low friction sheet 733.

Accordingly, when a control unit (not shown) drives the ultrasonic motor 725 to rotate with respect to the fixed barrel 712, the rollers 722 rotate about the shafts 720f because the joining member 729 is brought into frictional contact with the small diameter parts 722b of the rollers 722. As a result of the rotation of the rollers 722 about the shafts 720f, the rotation transmission ring 720 rotates about the optical axis (automatic focus operation).

In addition, when a manual operation input portion (not shown) gives a rotation force about the optical axis to the manual focus ring 724, the following action occurs. That is, the rollers 722 rotate about the shafts 720f by a friction force because the mount side end surface 724b of the manual focus ring 724 is brought into pressure contact with the large diameter parts 722a of the rollers 722. When the large diameter parts 722a of the rollers 722 rotate about the shafts 720f, the rotation transmission ring 720 rotates about the optical axis. In this case, the ultrasonic motor 725 does not rotate because of a friction retaining force between a rotor 725c and a stator 725b (manual focus operation).

Two focus keys 728 are mounted to the rotation transmission ring 720 at positions facing each other, and the focus key 728 is fitted to a notch portion 715b arranged on the tip of the cam ring 715. Accordingly, when the automatic focus operation or the manual focus operation is performed so that the rotation transmission ring 720 is rotated about the optical axis, the rotation force is transmitted to the cam ring 715 via the focus key 728.

When the cam ring 715 is rotated about the optical axis, the rear group barrel 716 whose rotation is restricted by the cam roller 717a and the linear guide groove 713a is moved forward and backward along the cam groove 715a of the cam ring 715 by the cam roller 717b. Thus, the focus lens 702 is driven, and the focus operation is performed.

While the interchangeable lens barrel for the single-lens reflex camera has been described as the optical apparatus of the present invention, the optical apparatus of the present invention can be applied to any optical apparatus including the drive unit including the ultrasonic motor, regardless of a type of the camera, including a compact camera, an electronic still camera, a personal digital assistant with a camera, and the like.

### (Vibration Device and Dust Removing Device)

A vibration device used, for example, for conveying and removing particles, powder, and droplets have been widely used in an electronic apparatus and the like.

As an example of the vibration device of the present invention, a dust removing device using the piezoelectric element of the present invention is described below.

The vibration device of the present invention includes a vibrating body including a diaphragm including the above-mentioned piezoelectric element or the above-mentioned multilayered piezoelectric element. The dust removing device of the present invention includes a vibration unit including the vibration device.

Fig. 14A and Fig. 14B are each a schematic view for illustrating a dust removing device according to one embodiment of the present invention. A dust removing device 310 includes plate-like piezoelectric elements 330 and a diaphragm 320. A material for the diaphragm 320 is not limited. When the dust removing device 310 is used for an optical device, a light transmissive material or a light reflective material may be used as the diaphragm 320.

Parts (a) to (c) of Fig. 15 are schematic views for illustrating the configuration of the piezoelectric element 330 in Fig. 14A. Parts (a) and (c) of Fig. 15 are illustrations of the configurations of the front and back surfaces of the piezoelectric element 330, and part (b) of Fig. 15 is an illustration of the configuration of the side surface thereof. As illustrated in Fig. 14A, the piezoelectric element 330 includes a single crystal 331, a first electrode 332, and a second electrode 333, and the first electrode 332 and the second electrode 333 are arranged so as to be face the plate surface of the single crystal 331.

In part (c) of Fig. 15, the surface on which the first electrode 332 protruding in front of the piezoelectric element 330 is installed is defined as a first electrode surface 336, and in part (a) of Fig. 15, the surface on which the second electrode 333 protruding in front of the piezoelectric element 330 is installed is defined as a second electrode surface 337.

Herein, the electrode surface in the present invention refers to the surface of the piezoelectric element on which the electrode is installed, and the first electrode 332 may wrap around the second electrode surface 337, for example, as illustrated in part (b) of Fig. 15.

As illustrated in Fig. 14A and Fig. 14B, in the piezoelectric elements 330 and the diaphragm 320, the first electrode surface 336 of each of the piezoelectric elements 330 is fixed to a plate surface of the diaphragm 320. Then, stress is generated between the piezoelectric element 330 and the diaphragm 320 by driving the piezoelectric element 330, to thereby generate out-of-plane vibration in the diaphragm. The dust removing device 310 of the present invention is a device for removing foreign matter such as dust adhering to the surface of the diaphragm 320 through the out-of-plane vibration of the diaphragm 320. The out-of-plane vibration means elastic vibration that displaces the diaphragm into an optical axis direction, that is, the thickness direction of the diaphragm.

Parts (a) and (b) of Fig. 16 are each a schematic view for illustrating the vibration principle of the dust removing device 310 of the present invention. Part (a) of Fig. 16 is an illustration of a state in which the out-of-plane vibration is generated in the diaphragm 320 by applying AC voltages having the same phase to a pair of left and right piezoelectric elements 330, respectively. The polarization direction of the single crystal for forming the pair of left and right piezoelectric elements 330 is the same as the thickness direction of the piezoelectric elements 330, and the dust removing device 310 is driven in the seventh vibration mode.

Part (b) of Fig. 16 is an illustration of a state in which the out-of-plane vibration is generated in the diaphragm 320 by applying AC voltages having opposite phases that are opposite by 180° to the pair of left and right piezoelectric elements 330. The dust removing device 310 is driven in the sixth vibration mode. The dust removing device 310 of the present invention is a device capable of effectively removing dust adhering to the surface of the diaphragm by using at least two vibration modes properly depending on the case.

### (Image Pickup Apparatus)

Next, an image pickup apparatus of the present invention is described. The image pickup apparatus of the present invention includes at least the above-mentioned dust removing device and an image pickup element unit, and the above-mentioned diaphragm of the dust removing device is arranged on the light-receiving surface side of the image pickup element unit. Fig. 17 and Fig. 18 are views for illustrating a digital single-lens reflex camera serving as an example of the image pickup apparatus according to an exemplary embodiment of the present invention.

Fig. 17 is a front side perspective view of a camera main body 601 when viewed from an object side, for illustrating a state in which a photographing lens unit is removed. Fig. 18 is an exploded perspective view for illustrating the schematic configuration of an inner portion of the camera for describing peripheral structures of the dust removing device of the present invention and an image pickup unit 400.

A mirror box 605 that guides a photographing luminous flux having passed through a photographing lens is arranged in the camera main body 601, and a main mirror (quick return mirror) 606 is arranged in the mirror box 605. The main mirror 606 may have a state of being held at an angle of 45° with respect to a photographing optical axis in order to guide the photographing luminous flux in the direction of a penta dach mirror (not shown), and a state of being held at a position retracted from the photographing luminous flux in order to guide the photographing luminous flux in the direction of an image pickup element (not shown).

On the object side of a main body chassis 300 serving as the skeleton of the camera main body, the mirror box 605 and a shutter unit 200 are arranged in the stated order from the object side. In addition, the image pickup unit 400 is arranged on the photographer side of the main body chassis 300. The image pickup unit 400 is installed so that the image pickup surface of the image pickup element is adjusted to be parallel to the mounting surface of a mount portion 602 serving as a reference for mounting the photographing lens unit at a predetermined distance.

Herein, the digital single-lens reflex camera has been described as the image pickup apparatus of the present invention, but for example, a camera with an interchangeable photographing lens unit such as a mirrorless digital single-lens camera without the mirror box 605 may be used. In addition, the image pickup apparatus of the present invention can also be applied to a device that is required to remove dust adhering to the surface of an optical component, in particular, among various image pickup apparatus, such as a video camera with an interchangeable photographing lens unit, a copying machine, a fax machine, and a scanner, or electronic/electrical apparatus including image pickup apparatus.

### (Ultrasonic Probe)

Next, an ultrasonic probe of the present invention is described. The ultrasonic probe of the present invention includes the above-mentioned piezoelectric element, and transmits and receives a signal by the piezoelectric element.

Fig. 19 is a schematic sectional view for illustrating the ultrasonic probe according to one embodiment of the present invention.

An ultrasonic probe 1100 of Fig. 19 includes a plurality of piezoelectric elements 1101, a backing material 1102, an acoustic matching layer 1103, and an acoustic lens 1104. As illustrated in Fig. 19, the plurality of piezoelectric elements 1101 are arranged on the backing material 1102 so as to adhere thereto, and the acoustic matching layer 1103 that matches an acoustic impedance is formed on each surface serving as a transmitting/receiving surface of the piezoelectric elements 1101 on a side opposite to the backing material 1102.

The acoustic matching layer 1103 may be a single layer or a plurality of layers, preferably two or more layers. As a material to be used for the acoustic matching layer 1103, there may be used, for example, carbon, aluminum, an aluminum alloy (e.g., an AL-Mg alloy), a magnesium alloy, Macor glass, glass, fused quartz, copper graphite, polyethylene, polypropylene, polycarbonate, an ABC resin, polyphenylene ether, an ABS resin, an AAS resin, an AES resin, nylon, polyamide imide, polyethylene terephthalate, polycarbonate, an epoxy resin, or a urethane resin.

In addition, as the backing material 1102, there may be used, for example, a thermoplastic resin, such as natural rubber, ferrite rubber, an epoxy resin, vinyl chloride, polyvinyl butyral, an ABS resin, polyurethane, polyvinyl alcohol, polyethylene, polypropylene, polyacetal, polyethylene terephthalate, a fluororesin, polyethylene glycol, or polyethylene terephthalate, a product obtained by adding metal powder thereto, or a superhard material such as tungsten carbide.

The piezoelectric element 1101 may be integrated or may be divided into a plurality of pieces. Fig. 19 is an illustration of an example of a case in which the piezoelectric element 1101 is arranged so as to be divided. A flexible cable (not shown) is connected to electrodes of the respective piezoelectric elements so that signals transmitted and received by the piezoelectric elements can be input and output.

The acoustic lens 1104 adheres to the acoustic matching layer 1103. The acoustic lens 1104 is a member for converging ultrasonic waves transmitted from the piezoelectric elements 1101 toward the object, and has an arc shape in the example of Fig. 15. As a material for the acoustic lens 1104, for example, a rubber containing a silicone-based resin (rubber) as a main component is generally used.

When the ultrasonic probe 1100 is used, an AC voltage is applied to the piezoelectric elements 1101 through the flexible cable, and the piezoelectric elements are vibrated by the piezoelectric effect to transmit the ultrasonic waves from the piezoelectric elements 1101. In this case, when the acoustic impedance of the object to which the ultrasonic waves are applied is small, or when the ultrasonic waves are applied to the object through water or air, reflected waves caused by a great change in acoustic impedance can be suppressed by virtue of the presence of the acoustic matching layer 1103, and the ultrasonic waves to the object can be efficiently radiated thereto.

Then, at the time of reception, the piezoelectric elements 1101 are vibrated with the ultrasonic waves reflected from the inside of the object, and the vibration is electrically converted by the piezoelectric effect to provide a reception signal. At the time of transmission and reception, the conversion of electrical energy and mechanical energy is performed, and the conversion efficiency in this case depends on the magnitude of the electromechanical coupling coefficient.

### (Ultrasonic Diagnostic Apparatus)

Next, an ultrasonic diagnostic apparatus of the present invention is described. The ultrasonic diagnostic apparatus of the present invention includes at least the ultrasonic probe and an image output unit (image display unit). Fig. 20 is a schematic view for illustrating an ultrasonic diagnostic apparatus according to one embodiment of the present invention. An ultrasonic diagnostic apparatus 1110 of Fig. 20 includes an ultrasonic probe 1100, a cable 1111, a drive control unit 1113, and an image display unit 1112. A flexible cable of the ultrasonic probe 1100 and the drive control unit 1113 are connected by the cable 1111, and an AC voltage is applied from the drive control unit 1113 to a piezoelectric element 1101 of the ultrasonic probe 1100 via the cable 1111.

When the ultrasonic waves are radiated to the inside of the object from the ultrasonic probe 1100, the ultrasonic waves reflected from the inside of the object are converted into electric signals again by the ultrasonic probe and input to the image processing unit 1114 through the cable 1111. In the image processing unit 1114, image data is created by calculation from changes in delay time and signal intensity with respect to the AC voltage output from the drive control unit 1113. The created image data is output to the image display unit 1112.

### (Ultrasonic Diagnostic System)

Next, an ultrasonic diagnostic system of the present invention is described. The ultrasonic diagnostic system of the present invention includes the ultrasonic probe, a transmission unit that transmits a signal output from the ultrasonic probe, and a reception unit that receives the signal transmitted from the transmission unit.

Fig. 21 and Fig. 22 are schematic views for illustrating an ultrasonic diagnostic system according to one embodiment of the present invention. In an ultrasonic diagnostic system 1120 of Fig. 21, a signal obtained by the ultrasonic probe 1100 is transmitted from a transmission unit 1121, and the signal is received by a reception unit 1122. The received signal is used to create image data in an image processing unit 1114, and the image data is output on the image display unit 1112. The distance between the transmission unit 1121 and the reception unit 1122 may be large so that the transmission unit 1121 and the reception unit 1122 are arranged far apart from each other. As means for the transmission and the reception, wireless communication such as Wi-Fi (trademark) or Bluetooth (trademark) may be used, or communication via a network line obtained by connecting a network cable may be used.

In Fig. 22, the output signal is used to create image data in the image processing unit 1114, the data is transmitted as a signal from the transmission unit 1121, and the signal is received by the reception unit 1122. The received signal is output on the image display unit 1112.

### (Electronic Apparatus)

Next, an electronic apparatus of the present invention is described. The electronic apparatus of the present invention includes a piezoelectric acoustic component including the above-mentioned piezoelectric element or the above-mentioned multilayered piezoelectric element. The piezoelectric acoustic component includes a speaker, a buzzer, a microphone, and a surface acoustic wave (SAW) element.

Fig. 23 is an overall perspective view of a main body 931 of a digital camera, which is an example of an electronic apparatus according to an exemplary embodiment of the present invention, as viewed from the front. An optical apparatus 901, a microphone 914, a stroboscopic light emission unit 909, and a fill light unit 916 are arranged on the front surface of the main body 931. The microphone 914 is installed in the main body, and is hence indicated by a broken line. A hole shape for collecting external sound is provided in front of the microphone 914.

A power button 933, a speaker 912, a zoom lever 932, and a release button 908 for performing a focus operation are arranged on the top surface of the main body 931. The speaker 912 is installed in the main body 931, and is hence indicated by a broken line. A hole shape for transmitting sound to the outside is provided in front of the speaker 912.

The piezoelectric acoustic component of the present invention is used for at least one of the microphone 914, the speaker 912, or a surface acoustic wave element.

While the digital camera has been described as the electronic apparatus of the present invention, the electronic apparatus of the present invention can also be applied to various electronic apparatus each including the piezoelectric acoustic component, such as a sound reproduction device, a sound recording device, a cellular phone, or an information terminal.

As described above, the piezoelectric element of the present invention is suitably used for an ultrasonic motor, an optical apparatus, a vibration device, a dust removing device, an image pickup apparatus, an ultrasonic probe, an ultrasonic diagnostic apparatus, and an electronic apparatus.

The use of the piezoelectric element of the present invention can provide an ultrasonic motor having driving efficiency comparable to or higher than that in the case of using a piezoelectric element containing lead.

The use of the ultrasonic motor of the present invention can provide an optical apparatus having an operating speed and operating efficiency comparable to or higher than those in the case of using a piezoelectric element containing lead.

The use of the piezoelectric element of the present invention can provide a vibration device having a vibration ability comparable to or higher than that in the case of using a piezoelectric element containing lead.

The use of the vibration device of the present invention can provide a dust removing device having dust removing efficiency comparable to or higher than that in the case of using a piezoelectric element containing lead.

The use of the dust removing device of the present invention can provide an image pickup apparatus having a dust removing function comparable to or higher than that in the case of using a piezoelectric element containing lead.

The use of the piezoelectric element of the present invention can provide an ultrasonic probe having transmitting/receiving performance comparable to or higher than that in the case of using a piezoelectric element containing lead.

The use of the ultrasonic probe of the present invention can provide an ultrasonic diagnostic apparatus and an ultrasonic diagnostic system each having driving efficiency comparable to or higher than that in the case of using a piezoelectric element containing lead.

The use of the piezoelectric acoustic component including the piezoelectric element of the present invention can provide an electronic apparatus having a sound generating property comparable to or higher than that in the case of using a piezoelectric element containing lead.

The single crystal and piezoelectric element of the present invention can be used for devices, such as a motor, a liquid discharge head, a liquid discharge device, a piezoelectric actuator, a piezoelectric sensor, and a ferroelectric memory, in addition to the above-mentioned devices.

### [Examples]

The present invention is more specifically described below by way of Examples. However, the present invention is not limited to the following Examples.

The piezoelectric element of the present invention, and a device and an apparatus each using the piezoelectric element were produced by methods described below.

### (Example 1)

Barium titanate (BaTiO₃, Ba/Ti=0.999) having an average grain diameter of 100 nm, barium zirconate (BaZrO₃, Ba/Zr=1.002), trimanganese tetraoxide (Mn₃O₄), and titanium oxide for adjusting the ratio α of the sum of the numbers of moles of Ti and Zr to the sum of the numbers of moles of Ba were used as raw material powders for a matrix.

Those raw material powders were weighed so as to achieve the ratio of the composition formula Ba_{0.990}(Ti_{0.98},Zr_{0.02})O₃ containing titanium and barium as main components. Trimanganese tetraoxide (Mn₃O₄) and Bi₂O₃ were added to 1 mol of the oxide so that the content of Mn (metal Mn) was 0.01 in terms of mole and the content of Bi was 0.001 in terms of mole, respectively.

Further, the oxide to which Mn₃O₄ and Bi₂O₃ had been added was mixed by dry mixing for 24 hours through use of a ball mill. In order to granulate the resultant mixed powder, 3 parts by weight of a PVA binder based on the mixed powder was caused to adhere to the surface of the mixed powder through use of a spray dryer device. Thus, granulated powder was obtained.

Next, the resultant granulated powder was loaded into a mold of which a surface on the sample side had been mirror-finished, and a molding pressure of 200 MPa was applied thereto with a press molding machine to produce a rectangular parallelepiped compact. The compact may be further pressurized with a cold isostatic molding machine.

Next, the resultant compact was placed in an electric furnace, kept at a maximum temperature of 1,300°C for 5 hours, and sintered in an air atmosphere over a total of 24 hours to provide a rectangular parallelepiped matrix of 12 mm×18 mm×1.3 mm.

Next, the average equivalent circle diameter and relative density of crystal grains for forming the resultant matrix were evaluated. As a result, the average equivalent circle diameter was 2 µm, and the relative density was 98%. A polarizing microscope was mainly used for observing the crystal grains. A scanning electron microscope (SEM) was used for identifying the grain diameters of small crystal grains. The average equivalent circle diameter was calculated from the observation result. In addition, the relative density was evaluated through use of a theoretical density calculated from a lattice constant determined by X-ray diffraction and weighed composition, and a measured density by the Archimedes method.

Next, the resultant rectangular parallelepiped matrix was polished with a polisher on both surfaces to a thickness of 1.0 mm while the grain size of the abrasive grains was changed. Finally, chemical polishing was performed as a finish so as to provide a mirror surface.

Next, an alumina saggar coated with zirconia serving as a saggar 7, a zirconia setter serving as a setter 6, a zirconia setter serving as a weight 4, and zirconia beads serving as beads 5 were prepared, arranged as illustrated in Fig. 9, and placed in an electric furnace under a state of the saggar being covered with a lid, to be heated.

A seed single crystal used in this case was a BaTiO₃ (manufactured by Physcience Opto-electronics) substrate of 10 mm×15 mm×1 mm, in which upper and lower surfaces were (110) planes, and both the surfaces were mirror-polished. In the present invention, the upper and lower surfaces refer to a surface in contact with the main surface of the matrix and a surface on an opposite side thereof.

A temperature increase profile during heating was such that the temperature was increased from room temperature to a liquid-phase start temperature of 1,320°C over 8.8 hours at a rate of temperature increase of 150°C/h, and then the temperature was increased from 1,320°C to 1,400°C over 100 hours at a rate of temperature increase of 0.80°C/h. After that, the temperature was kept at 1,400°C for 1,000 hours, and finally, the temperature was decreased to room temperature by natural cooling.

Next, the portion of the seed single crystal was removed by polishing, the upper and lower surfaces were polished, and after a single crystal portion in a thickness direction was observed, the single crystal portion was cut out with a dicing saw to provide a single crystal.

Next, the crystal structure of the resultant single crystal was analyzed by X-ray diffraction. As illustrated in Fig. 4A and Fig. 4B, (110) orientation was observed from a (110) pole figure and a (200) pole figure. In addition, the relative density of the resultant single crystal was measured. As a result, the relative density was 98%.

Next, the composition of the resultant single crystal was evaluated by ICP emission spectrometry. As a result, the composition of Ba, Ti, Zr, Mn, and Bi after the heating matched the weighed composition thereof.

Next, gold electrodes each having a thickness of 400 nm were formed on the front and back surfaces of the single crystal by a DC sputtering method. Titanium was formed into a film having a thickness of 30 nm as a contact layer between each of the electrodes and the single crystal.

The single crystal with electrodes was cut into sizes of 10 mm×0.2 mm×0.3 mm (k'₃₃ evaluation element, Fig. 2) and 10 mm×2.5 mm×0.3 mm (k₃₁ evaluation element, Fig. 1) so that the side surface of a long side was a (100) plane, to produce strip-shaped piezoelectric elements of the present invention. The resultant piezoelectric elements were subjected to polarization treatment by setting the surface of a hot plate to from 60°C to 100°C and applying an electric field of 1 kV/mm for 30 minutes on the hot plate.

As shown in Fig. 6, the phase transition temperature Tot between a tetragonal system and an orthorhombic system of the piezoelectric element subjected to the polarization treatment was set as the temperature at which a dielectric constant took the maximum value, which appeared at a temperature lower than a Curie temperature Tc when a measurement temperature was increased from a low temperature to the Curie temperature Tc or higher through use of the k₃₁ element. In Example 1, the Tot was 10°C, and it was found that the piezoelectric element was a tetragonal system when an environmental temperature was from 10°C to 60°C and was a tetragonal system when the environmental temperature was 25°C.

In Table 2, those which are the tetragonal system in the entire range of an environmental temperature of from 10°C to 60°C are represented as "○" in the column of "Tetragonal system at from 10°C to 60°C", and those except the foregoing are represented as "×" in the column of "Tetragonal system at from 10°C to 60°C".

A k₃₃ evaluation element was a prism of 0.8 mm×0.8 mm×5.0 mm before the attachment of electrodes, and was cut out by dicing so that the crystal orientation of the upper and lower surfaces of the prism was (110). A platinum paste was applied to the above-mentioned (110) plane of 0.8 mm×0.8 mm, and heat treatment was performed at 1,200°C for 2 hours to form electrodes on the upper and lower surfaces.

Next, as static characteristics of the piezoelectric element including the single crystal of the present invention, the electromechanical coupling coefficients k₃₁, k₃₃, and k'₃₃ of the piezoelectric element subjected to the polarization treatment were evaluated by a resonance-antiresonance method at room temperature (25°C) with an impedance analyzer (4294A manufactured by Agilent Technologies). k₃₃ and k'₃₃ relate to a piezoelectric longitudinal effect. The results are shown in Table 2. It was found that those samples had large electromechanical coupling coefficients as a lead-free piezoelectric material, with a k₃₁ of 32.1%, a k₃₃ of 73.4%, and a k'₃₃ of 68.8%.

Next, the coercive electric field of the piezoelectric element was evaluated. Through use of a ferroelectric/piezoelectric evaluation system (LC II manufactured by Radiant Technologies, Inc.), an electric field at the time of a polarization amount of 0 was read from a PE hysteresis curve obtained from a polarization amount with respect to an electric field in a hysteresis measurement mode of Fig. 7, and the value was defined as a coercive electric field. A coercive electric field Ec at this time was 6.58 kV/cm.

From the resultant values of k'₃₃ and the coercive electric field Ec, a piezoelectric element figure of merit (k'₃₃×Ec) was a very high value of 453, which indicated that k'₃₃ and the coercive electric field Ec were able to be achieved at the same time.

### (Example 2)

Barium titanate (BaTiO₃, Ba/Ti=0.999) having an average grain diameter of 100 nm, barium zirconate (BaZrO₃, Ba/Zr=1.002), trimanganese tetraoxide (Mn₃O₄), and titanium oxide for adjusting the ratio α of the sum of the numbers of moles of Ti and Zr to the sum of the numbers of moles of Ba were used as raw material powders for a matrix.

Those raw material powders were weighed so as to achieve the ratio of the composition formula Ba_{0.990}(Ti_{0.98},Zr_{0.02})O₃ containing titanium and barium as main components. Trimanganese tetraoxide (Mn₃O₄) and Bi₂O₃ were added to 1 mol of the oxide so that the content of Mn (metal Mn) was 0.01 in terms of mole and the content of Bi was 0.001 in terms of mole, respectively.

Further, the oxide to which Mn₃O₄ and Bi₂O₃ had been added was mixed by dry mixing for 24 hours through use of a ball mill. In order to granulate the resultant mixed powder, 3 parts by weight of a PVA binder based on the mixed powder was caused to adhere to the surface of the mixed powder through use of a spray dryer device. Thus, granulated powder was obtained.

Next, the resultant granulated powder was loaded into a mold of which a surface on the sample side had been mirror-finished, and a molding pressure of 200 MPa was applied thereto with a press molding machine to produce a rectangular parallelepiped compact.

Next, the resultant compact was placed in an electric furnace, kept at a maximum temperature of 1,300°C for 5 hours, and sintered in an air atmosphere over a total of 24 hours to provide a rectangular parallelepiped matrix of 12 mm×18 mm×1.3 mm.

Next, the average equivalent circle diameter and relative density of crystal grains for forming the resultant matrix were evaluated. As a result, the average equivalent circle diameter was 2 µm, and the relative density was 98%. A polarizing microscope was mainly used for observing the crystal grains. A scanning electron microscope (SEM) was used for identifying the grain diameters of small crystal grains. The average equivalent circle diameter was calculated from the observation result. In addition, the relative density was evaluated through use of a theoretical density calculated from a lattice constant determined by X-ray diffraction and weighed composition, and a measured density by the Archimedes method.

Next, the resultant rectangular parallelepiped matrix was polished with a polisher on both surfaces to a thickness of 1.0 mm while the grain size of the abrasive grains was changed. Finally, chemical polishing was performed as a finish so as to provide a mirror surface.

Next, an alumina saggar coated with zirconia serving as a saggar 7, a zirconia setter serving as a setter 6, a zirconia setter serving as a weight 4, and zirconia beads serving as beads 5 were prepared, arranged as illustrated in Fig. 9, and placed in an electric furnace under a state of the saggar being covered with a lid, to be heated.

A seed single crystal used in this case was a BaTiO₃ (manufactured by Physcience Opto-electronics) substrate of 10 mm×15 mm×1 mm, in which upper and lower surfaces were (111) planes, and both the surfaces were mirror-polished.

A temperature increase profile during heating was such that the temperature was increased from room temperature to a liquid-phase start temperature of 1,320°C over 8.8 hours at a rate of temperature increase of 150°C/h, and then the temperature was increased from 1,320°C to 1,400°C over 100 hours at a rate of temperature increase of 0.80°C/h. After that, the temperature was kept at 1,400°C for 1,000 hours, and finally, the temperature was decreased to room temperature by natural cooling.

Next, the portion of the seed single crystal was removed by polishing, the upper and lower surfaces were polished, and after a single crystal portion in a thickness direction was observed, the single crystal portion was cut out with a dicing saw to provide a single crystal.

Next, the crystal structure of the resultant single crystal was analyzed by X-ray diffraction. As illustrated in Fig. 5A and Fig. 5B, (111) orientation was observed from a (111) pole figure and a (200) pole figure. In addition, the relative density of the resultant single crystal was measured. As a result, the relative density was 98%.

Next, the composition of the single crystal obtained by ICP emission spectrometry was evaluated. As a result, the composition of Ba, Ti, Zr, Mn, and Bi after the heating matched the weighed composition thereof.

Next, gold electrodes each having a thickness of 400 nm were formed on the front and back surfaces of the single crystal by a DC sputtering method. Titanium was formed into a film having a thickness of 30 nm as a contact layer between each of the electrodes and the single crystal.

The single crystal with electrodes was cut into sizes of 10 mm×0.2 mm×0.3 mm (k'₃₃ evaluation element, Fig. 2) and 10 mm×2.5 mm×0.3 mm (k₃₁ evaluation element, Fig. 1) to produce strip-shaped piezoelectric elements of the present invention. The resultant piezoelectric elements were subjected to polarization treatment by setting the surface of a hot plate to from 60°C to 100°C and applying an electric field of 1 kV/mm for 30 minutes on the hot plate.

The phase transition temperature Tot between a tetragonal system and an orthorhombic system of the piezoelectric element subjected to the polarization treatment was set as the temperature at which a dielectric constant took the maximum value when a measurement temperature was increased from a low temperature to a Curie temperature Tc or higher through use of the k₃₁ element. The Tot was 9°C, and it was found that the piezoelectric element was a tetragonal system when an environmental temperature was from 10°C to 60°C and was a tetragonal system when the environmental temperature was 25°C.

A k₃₃ evaluation element was a prism of 0.8 mm×0.8 mm×5.0 mm before the attachment of electrodes, and was cut out by dicing so that the crystal orientation of the upper and lower surfaces of the prism was (111). A platinum paste was applied to the (111) plane of 0.8 mm×0.8 mm, and heat treatment was performed at 1,200°C for 2 hours to form upper and lower electrodes.

Next, as static characteristics of the piezoelectric element including the single crystal of the present invention, the electromechanical coupling coefficients k₃₁, k₃₃, and k'₃₃ of the piezoelectric element subjected to the polarization treatment were evaluated by a resonance-antiresonance method at room temperature (25°C) with an impedance analyzer (4294A manufactured by Agilent Technologies). The results are shown in Table 2. It was found that those samples had a k₃₁ of 31.2%, a k₃₃ of 72.8%, and a k'₃₃ of 67.4%, which were large as the electromechanical coupling coefficients of a lead-free piezoelectric material.

Next, the coercive electric field of the piezoelectric element was evaluated. Through use of a ferroelectric/piezoelectric evaluation system (LC II manufactured by Radiant Technologies, Inc.), an electric field at the time of a polarization amount of 0 was read from a PE hysteresis curve obtained from a polarization amount with respect to an electric field in a hysteresis measurement mode, and the value was defined as a coercive electric field. A coercive electric field Ec at this time was 7.50 kV/cm.

From the resultant values of the k'₃₃ and the coercive electric field Ec, a piezoelectric element figure of merit (k'₃₃×Ec) was a very high value of 506, which indicated that the k'₃₃ and the coercive electric field Ec were able to be achieved at the same time.

### (Examples 4, 6 to 8, 11, 12, and 20)

Single crystals and piezoelectric elements of the present invention were each obtained by the same process as in Example 2 except that the respective values were changed as shown in Table 1.

The electromechanical coupling coefficients k₃₁, k₃₃, and k'₃₃, and coercive electric fields Ec of the piezoelectric elements of the present invention were evaluated by the same process as in Example 2. The results are shown in Table 2.

### (Examples 3, 5, 9, 10, 13 to 19, and 21 to 23)

Single crystals and piezoelectric elements of the present invention were each obtained by the same process as in Example 1 except that the respective values were changed as shown in Table 1.

The electromechanical coupling coefficients k₃₁, k₃₃, and k'₃₃, and coercive electric fields Ec of the piezoelectric elements of the present invention were evaluated by the same process as in Example 1. The results are shown in Table 2.

### (Examples 24 to 27)

Barium titanate (BaTiO₃, Ba/Ti=0.999) having an average grain diameter of 100 nm, barium zirconate (BaZrO₃, Ba/Zr=1.002), trimanganese tetraoxide (Mn₃O₄), and titanium oxide for adjusting the ratio α of the sum of the numbers of moles of Ti and Zr to the sum of the numbers of moles of Ba were used as raw material powders for a matrix. Those raw material powders were weighed so as to achieve the ratio of the composition formula Ba_{0.990}(Ti_{0.98},Zr_{0.02})O₃ containing titanium and barium as main components.

As shown in Table 1, trimanganese tetraoxide (Mn₃O₄) and Bi₂O₃ were added as Mn and Bi, respectively, to 1 mol of the oxide so that the content of metal Mn was 0.015 in terms of mole in each of Examples 24 and 25, the content of metal Mn was 0.020 in terms of mole in each of Examples 26 and 27, the content of metal Bi was 0.002 in terms of mole in each of Examples 24 and 26, and the content of metal Bi was 0.003 in terms of mole in each of Examples 25 and 27.

Further, 3 parts by mole to 7 parts by mole of lithium carbonate Li₂CO₃ serving as a single crystallization promoter was added to 1 mol of a perovskite-type metal oxide obtained by adding metal Mn and metal Bi to the main component composition Ba_{0.990}(Ti_{0.98},Zr_{0.02})O₃. The oxide to which Mn₃O₄, Bi₂O₃, and Li₂CO₃ had been added was mixed by dry mixing for 24 hours through use of a ball mill. In order to granulate the resultant mixed powder, 3 parts by weight of a PVA binder based on the mixed powder was caused to adhere to the surface of the mixed powder through use of a spray dryer device. Thus, granulated powder was obtained.

Single crystals and piezoelectric elements of the present invention were each obtained by performing the same process as in Example 1 as the subsequent process.

The electromechanical coupling coefficients k₃₁, k₃₃, and k'₃₃, and coercive electric fields Ec of the piezoelectric elements of the present invention were evaluated by the same process as in Example 1. The results are shown in Table 2.

### (Comparative Example 1)

Barium titanate (BaTiO₃, Ba/Ti=0.999) having an average grain diameter of 100 nm, barium zirconate (BaZrO₃, Ba/Zr=1.002), trimanganese tetraoxide (Mn₃O₄), and titanium oxide for adjusting the ratio α of the sum of the numbers of moles of Ti and Zr to the sum of the numbers of moles of Ba were used as raw material powders for a matrix.

Those raw material powders were weighed so as to achieve the ratio of the composition formula Ba_{0.990}(Ti_{0.98},Zr_{0.02})O₃ containing titanium and barium as main components. Trimanganese tetraoxide (Mn₃O₄) and Bi₂O₃ were added as Mn and Bi, respectively, to 1 mol of the oxide so that the content of metal Mn was 0.01 in terms of mole and the content of metal Bi was 0.001 in terms of mole.

Further, the oxide to which Mn₃O₄ and Bi₂O₃ had been added was mixed by dry mixing for 24 hours through use of a ball mill. In order to granulate the resultant mixed powder, 3 parts by weight of a PVA binder based on the mixed powder was caused to adhere to the surface of the mixed powder through use of a spray dryer device. Thus, granulated powder was obtained.

Next, the resultant granulated powder was loaded into a mold of which a surface on the sample side had been mirror-finished, and a molding pressure of 200 MPa was applied thereto with a press molding machine to produce a rectangular parallelepiped compact.

Next, the resultant compact was placed in an electric furnace, kept at a maximum temperature of 1,300°C for 5 hours, and sintered in an air atmosphere over a total of 24 hours to provide a rectangular parallelepiped matrix of 12 mm×18 mm×1.3 mm.

Next, the average equivalent circle diameter and relative density of crystal grains for forming the resultant matrix were evaluated. As a result, the average equivalent circle diameter was 4 µm, and the relative density was 98%. A polarizing microscope was mainly used for observing the crystal grains. A scanning electron microscope (SEM) was used for identifying the grain diameters of small crystal grains. The average equivalent circle diameter was calculated from the observation result. In addition, the relative density was evaluated through use of a theoretical density calculated from a lattice constant determined by X-ray diffraction and weighed composition, and a measured density by the Archimedes method.

Next, the resultant rectangular parallelepiped matrix was polished with a polisher on both surfaces to a thickness of 1.0 mm while the grain size of the abrasive grains was changed. Finally, chemical polishing was performed as a finish so as to provide a mirror surface.

Next, an alumina saggar coated with zirconia serving as a saggar 7, a zirconia setter serving as a setter 6, a zirconia setter serving as a weight 4, and zirconia beads serving as beads 5 were prepared, arranged as illustrated in Fig. 9, and placed in an electric furnace under a state of the saggar being covered with a lid, to be heated.

A seed single crystal used in this case was a BaTiO₃ (manufactured by Physcience Opto-electronics) substrate of 10 mm×15 mm×1 mm, in which upper and lower surfaces were (100) planes, and both the surfaces were mirror-polished.

A temperature increase profile during heating was such that the temperature was increased from room temperature to a liquid-phase start temperature of 1,320°C over 8.8 hours at a rate of temperature increase of 150°C/h, and then the temperature was increased from 1,320°C to 1,400°C over 100 hours at a rate of temperature increase of 0.80°C/h. After that, the temperature was kept at 1,400°C for 1,000 hours, and finally, the temperature was decreased to room temperature by natural cooling.

Next, the portion of the seed single crystal was removed by polishing, the upper and lower surfaces were polished, and after a single crystal portion in a thickness direction was observed, the single crystal portion was cut out with a dicing saw to provide a single crystal.

Next, the crystal structure of the resultant single crystal was analyzed by X-ray diffraction. As illustrated in Fig. 3A and Fig. 3B, (100) orientation was observed from a (200) pole figure and a (110) pole figure. In addition, the relative density of the resultant single crystal was measured. As a result, the relative density was 98%.

Next, the composition of the resultant single crystal was evaluated by ICP emission spectrometry. As a result, the composition of Ba, Ti, Zr, Mn, and Bi after the heating matched the weighed composition thereof.

Next, gold electrodes each having a thickness of 400 nm were formed on the front and back surfaces of the single crystal by a DC sputtering method. Titanium was formed into a film having a thickness of 30 nm as a contact layer between each of the electrodes and the single crystal.

The single crystal with electrodes was cut into sizes of 10 mm×0.2 mm×0.3 mm (k'₃₃ evaluation element, Fig. 2) and 10 mm×2.5 mm×0.3 mm (k₃₁ evaluation element, Fig. 1) so that the upper and lower surfaces were (100) planes, and the side surface was a (110) plane, to produce strip-shaped piezoelectric elements of Comparative Example 1. The resultant piezoelectric elements were subjected to polarization treatment by setting the surface of a hot plate to from 60°C to 100°C and applying an electric field of 1 kV/mm for 30 minutes on the hot plate.

The phase transition temperature Tot between a tetragonal system and an orthorhombic system of the piezoelectric element subjected to the polarization treatment was set as the temperature at which a dielectric constant took the maximum value when a measurement temperature was increased from a low temperature to a Curie temperature Tc or higher through use of the k₃₁ element. The Tot was 10°C, and it was found that the piezoelectric element was a tetragonal system when an environmental temperature was from 10°C to 60°C and was a tetragonal system when the environmental temperature was 25°C.

A k₃₃ evaluation element was a prism of 0.8 mm×0.8 mm×5.0 mm before the attachment of electrodes, and was cut out by dicing so that the crystal orientation of the upper and lower surfaces of the prism was (100).

Next, as static characteristics of the piezoelectric element, the electromechanical coupling coefficients k₃₁, k₃₃, and k'₃₃ of the piezoelectric element subjected to the polarization treatment were evaluated by a resonance-antiresonance method at room temperature (25°C) with an impedance analyzer (4294A manufactured by Agilent Technologies). The results are shown in Table 2. It was found that those samples had relatively small electromechanical coupling coefficients, with a k₃₁ of 19.1%, a k₃₃ of 44.6%, and a k'₃₃ of 41.3%.

Next, the coercive electric field of the piezoelectric element was evaluated. Through use of a ferroelectric/piezoelectric evaluation system (LC II manufactured by Radiant Technologies, Inc.), an electric field at the time of a polarization amount of 0 was read from a PE hysteresis curve obtained from a polarization amount with respect to an electric field in a hysteresis measurement mode, and the value was defined as a coercive electric field. The coercive electric field at this time was 4.19 kV/cm.

It was indicated that the k'₃₃ and the coercive electric field Ec could not be achieved at the same time because a piezoelectric element figure of merit (k'₃₃×Ec) formed of the resultant values of the k'₃₃ and the coercive electric field Ec was 173, which was 200 or less.

### (Comparative Example 2)

A single crystal and a piezoelectric element were obtained by the same process as in Comparative Example 1 except that the respective values were changed as shown in Table 1.

The electromechanical coupling coefficients k₃₁, k₃₃, and k'₃₃, and coercive electric field of the piezoelectric element were evaluated by the same process as in Comparative Example 1. The results are shown in Table 2.

The phase transition temperature Tot between a tetragonal system and an orthorhombic system of the piezoelectric element subjected to the polarization treatment of Comparative Example 2 was 10°C, and it was found that the piezoelectric element was a tetragonal system in the range of an environmental temperature of from 10°C to 60°C and was a tetragonal system when the environmental temperature was 25°C.

### (Comparative Examples 3 to 5)

Single crystals and piezoelectric elements were each obtained by the same process as in Example 1 except that the respective values were changed as shown in Table 1.

The electromechanical coupling coefficients k₃₁, k₃₃, and k'₃₃, and coercive electric fields of the piezoelectric elements were evaluated by the same process as in Example 1. The results are shown in Table 2.

The phase transition temperatures Tot between a tetragonal system and an orthorhombic system of the piezoelectric elements subjected to polarization treatment of Comparative Examples 3, 4, and 5 were 26°C, 29°C, and 34°C, respectively. It was found that each of the piezoelectric elements was an orthorhombic system at an environmental temperature of room temperature (25°C) and was not a tetragonal system at an environmental temperature in the range of from 10°C to 60°C (represented as "×" in the column of "Tetragonal system at from 10°C to 60°C" in Table 2).

### (Comparative Examples 6 and 7)

In each of Comparative Examples 6 and 7, in the matrix after the heating, no region in which a single crystal portion spread from the seed single crystal was observed, and hence a single crystal could not be obtained.

### [Table 1]

**Table 1**

| | Main component | | | First subcomponent | Second subcomponent | Crystal orientation |
|---|---|---|---|---|---|---|
| | Ba | Ti | Zr | Mn | Bi | |
| | α | 1-x | x | mol | mol | |
| Example 1 | 0.99 | 0.98 | 0.02 | 0.010 | 0.001 | (110) |
| Example 2 | 0.99 | 0.98 | 0.02 | 0.010 | 0.001 | (111) |
| Example 3 | 0.99 | 0.98 | 0.02 | 0.010 | 0.002 | (110) |
| Example 4 | 0.99 | 0.98 | 0.02 | 0.010 | 0.002 | (111) |
| Example 5 | 0.99 | 0.98 | 0.02 | *0.005* | 0.002 | (110) |
| Example 6 | 0.99 | 0.98 | 0.02 | *0.005* | 0.002 | (111) |
| Example 7 | 0.99 | 0.98 | 0.02 | 0.020 | 0.003 | (111) |
| Example 8 | 0.99 | 0.98 | 0.02 | 0.020 | *0.005* | (111) |
| Example 9 | 0.99 | 0.98 | 0.02 | 0.020 | 0 | (110) |
| Example 10 | 0.99 | 0.98 | 0.02 | 0.030 | 0.006 | (110) |
| Example 11 | 0.99 | 0.98 | 0.02 | 0.030 | 0.0004 | (111) |
| Example 12 | 0.99 | 0.98 | 0.02 | 0.040 | 0.007 | (111) |
| Example 13 | 0.99 | 0.98 | 0.02 | 0.002 | 0.0005 | (110) |
| Example 14 | 0.99 | 0.98 | 0.02 | 0.060 | 0.002 | (110) |
| Example 15 | 0.99 | 0.97 | 0.03 | 0.030 | 0.002 | (110) |
| Example 16 | 0.99 | 0.995 | *0.005* | 0.010 | 0.001 | (110) |
| Example 17 | 0.98 | 0.99 | 0.01 | 0.010 | 0.0005 | (110) |
| Example 18 | 0.98 | 0.99 | 0.01 | 0.010 | 0.001 | (110) |
| Example 19 | 0.98 | 0.98 | 0.02 | 0.002 | 0.0005 | (110) |
| Example 20 | 0.98 | 0.97 | 0.03 | 0.040 | 0.004 | (111) |
| Example 21 | 0.98 | 0.97 | 0.03 | *0.050* | 0.004 | (110) |
| Example 22 | 1.02 | 0.99 | 0.01 | 0.010 | 0.006 | (110) |
| Example 23 | 1.02 | 0.99 | 0.01 | *0.050* | 0.001 | (110) |
| Example 24 | 0.99 | 0.98 | 0.02 | 0.015 | 0.002 | (110) |
| Example 25 | 0.99 | 0.98 | 0.02 | 0.015 | 0.003 | (110) |
| Example 26 | 0.99 | 0.98 | 0.02 | 0.020 | 0.002 | (110) |
| Example 27 | 0.99 | 0.98 | 0.02 | 0.020 | 0.003 | (110) |
| Comparative Example 1 | 0.990 | 0.980 | 0.020 | 0.0100 | 0.0010 | (100) |
| Comparative Example 2 | 0.990 | 0.980 | 0.020 | *0.0050* | 0.0020 | (100) |
| Comparative Example 3 | 0.990 | 0.960 | 0.040 | 0.0100 | 0.0010 | (110) |
| Comparative Example 4 | 0.990 | 0.950 | *0.050* | 0.0400 | 0.0040 | (110) |
| Comparative Example 5 | 0.990 | 0.940 | 0.060 | 0.0400 | 0.0040 | (110) |
| Comparative Example 6 | 1.050 | 0.980 | 0.020 | 0.0200 | 0.0030 | (111) |
| Comparative Example 7 | 0.970 | 0.980 | 0.020 | 0.0200 | 0.0030 | (111) |

### [Table 2]

**Table 2**

| | k31 | k33 | k'33 | Ec | k'33*Ec | Phase transition temperature Tot | Crystal system at 25°C | Tetragonal system at from 10°C to 60°C |
|---|---|---|---|---|---|---|---|---|
| | % | % | % | kV/cm | | °C | | |
| Example 1 | 32.1 | 73.4 | 68.8 | 6.58 | 453 | 10 | Tetragonal | ○ |
| Example 2 | 31.2 | 72.8 | 67.4 | 7.50 | 506 | 9 | Tetragonal | ○ |
| Example 3 | 32.5 | 74.0 | 69.3 | 6.02 | 417 | 2 | Tetragonal | ○ |
| Example 4 | 32.2 | 73.9 | 69.2 | 8.45 | 585 | 2 | Tetragonal | ○ |
| Example 5 | 33.8 | 76.1 | 71.2 | 5.23 | 372 | 10 | Tetragonal | ○ |
| Example 6 | 32.5 | 73.9 | 69.1 | 7.66 | 529 | 9 | Tetragonal | ○ |
| Example 7 | 32.7 | 75.1 | 70.4 | 8.64 | 608 | 0 | Tetragonal | ○ |
| Example 8 | 33.1 | 75.4 | 70.8 | 8.55 | 605 | -3 | Tetragonal | ○ |
| Example 9 | 30.2 | 69.4 | 64.9 | 3.22 | 209 | 17 | Tetragonal | × |
| Example 10 | 31.5 | 72.2 | 68.6 | 6.74 | 462 | -4 | Tetragonal | ○ |
| Example 11 | 29.2 | 68.4 | 63.7 | 4.63 | 295 | 15 | Tetragonal | × |
| Example 12 | 24.5 | 56.9 | 51.7 | 6.16 | 318 | -11 | Tetragonal | × |
| Example 13 | 32.4 | 74.9 | 70.1 | 5.14 | 360 | 12 | Tetragonal | × |
| Example 14 | 20.1 | 47.8 | 43.1 | 6.75 | 291 | -8 | Tetragonal | ○ |
| Example 15 | 33.2 | 75.8 | 72.3 | 5.84 | 422 | 13 | Tetragonal | × |
| Example 16 | 22.0 | 49.5 | 45.4 | 6.42 | 291 | -9 | Tetragonal | ○ |
| Example 17 | 30.2 | 69.4 | 65.3 | 6.68 | 436 | 9 | Tetragonal | ○ |
| Example 18 | 30.1 | 69.0 | 63.8 | 6.72 | 429 | 4 | Tetragonal | ○ |
| Example 19 | 33.3 | 76.2 | 73.1 | 5.11 | 374 | 11 | Tetragonal | × |
| Example 20 | 32.4 | 74.4 | 69.7 | 7.89 | 550 | 12 | Tetragonal | × |
| Example 21 | 32.2 | 73.7 | 68.8 | 5.68 | 391 | 10 | Tetragonal | ○ |
| Example 22 | 30.1 | 68.0 | 64.5 | 6.31 | 407 | -4 | Tetragonal | ○ |
| Example 23 | 30.0 | 67.2 | 62.4 | 7.14 | 446 | -3 | Tetragonal | ○ |
| Example 24 | 31.1 | 72.3 | 67.1 | 10.90 | 731 | 10 | Tetragonal | ○ |
| Example 25 | 29.3 | 67.8 | 58.2 | 12.20 | 710 | 3 | Tetragonal | ○ |
| Example 26 | 27.9 | 63.1 | 54.1 | 11.50 | 622 | 4 | Tetragonal | ○ |
| Example 27 | 25.6 | 60.2 | 50.1 | 12.30 | 616 | 0 | Tetragonal | ○ |
| Comparative Example 1 | 19.1 | 44.6 | 41.3 | 4.19 | 173 | 10 | Tetragonal | ○ |
| Comparative Example 2 | 19.3 | 44.6 | 41.3 | 4.19 | 173 | 10 | Tetragonal | ○ |
| Comparative Example 3 | 33.1 | 76.4 | 72.6 | 2.18 | 158 | 26 | Orthorhombic | × |
| Comparative Example 4 | 34.2 | 79.1 | 75.1 | 2.33 | 175 | 29 | Orthorhombic | × |
| Comparative Example 5 | 34.5 | 79.6 | 75.4 | 1.81 | 136 | 34 | Orthorhombic | × |
| Comparative Example 6 | - | - | - | - | - | - | - | - |
| Comparative Example 7 | - | - | - | - | - | - | - | - |

### (Example 28)

An ultrasonic motor illustrated in Fig. 11 was produced through use of the piezoelectric element of Example 1. In the produced ultrasonic motor, the rotation of the motor in response to the application of an AC voltage was recognized.

### (Example 29)

An optical apparatus illustrated in Fig. 13 was produced through use of the ultrasonic motor of Example 28. In the produced optical apparatus, an autofocus operation in response to the application of an AC voltage was recognized.

### (Example 30)

A dust removing device illustrated in each of Fig. 14A and Fig. 14B was produced through use of the piezoelectric element of Example 1. In the produced dust removing device, when plastic beads were sprayed and an AC voltage was applied, a satisfactory dust removing rate was recognized.

### (Example 31)

An image pickup apparatus illustrated in Fig. 18 was produced through use of the dust removing device of Example 30. When the produced image pickup apparatus was operated, dust on the surface of the image pickup unit was satisfactorily removed, and an image without dust defects was obtained.

### (Example 32)

An ultrasonic probe illustrated in Fig. 19 was produced through use of the piezoelectric element of Example 1. In the produced ultrasonic probe, ultrasonic waves were transmitted by the application of an AC voltage, and a reception signal caused by reflection from the inside of an object was recognized.

### (Example 33)

An ultrasonic diagnostic apparatus illustrated in Fig. 20 was produced through use of the ultrasonic probe of Example 32. When the produced ultrasonic diagnostic apparatus was operated, an image of the inside of an object was clearly output.

### (Example 34)

An ultrasonic diagnostic system illustrated in Fig. 21 was produced through use of the ultrasonic probe of Example 33. When the produced ultrasonic diagnostic system was operated and an image was displayed on an image display unit, an image of the inside of an object was clearly output.

### (Example 35)

An electronic apparatus illustrated in Fig. 23 was produced through use of the piezoelectric element of Example 1. In the produced electronic apparatus, a speaker operation in response to the application of an AC voltage was recognized.

### [Industrial Applicability]

The piezoelectric element of the present invention has a large electromechanical coupling coefficient indicating piezoelectric performance and a large coercive electric field. Accordingly, the single crystal of the present invention can be used without problems in many devices such as an ultrasonic motor, a dust removing device, and an ultrasonic probe. The above-mentioned technology can be used even in the configuration in which the single crystal contains less than 1,000 ppm of Pb, and hence the technology described in this description can contribute to the achievement of a sustainable society such as a decarbonized/recycling-oriented society.

The present invention is not limited to the embodiments described above, and various changes and modifications may be made without departing from the spirit and scope of the present invention. Accordingly, the following claims are appended hereto in order to make the scope of the present invention public.

The present application claims priority based on Japanese Patent Application No. 2024-015528 filed on February 5, 2024, and Japanese Patent Application No. 2024-215920 filed on December 10, 2024, and the entire contents thereof are incorporated herein by reference.

### [Reference Signs List]

1 matrix
2 seed single crystal
3 single crystal
4 weight
5 bead
6 setter
7 saggar
8 lid
11 first electrode
33 second electrode
201 vibrator
202 rotor
203 output shaft
2011 elastic ring
2012 piezoelectric element
2013 organic adhesive
310 dust removing device
320 diaphragm
330 piezoelectric element
331 single crystal
332 first electrode
333 second electrode
336 first electrode surface
337 second electrode surface
601 camera main body
602 mount portion
605 mirror box
606 main mirror
200 shutter unit
300 main body chassis
400 image pickup unit
701 front group lens
702 rear group lens (focus lens)
711 attaching/detaching mount
712 fixed barrel
713 linear guide barrel
714 front group barrel
715 cam ring
716 rear group barrel
717 cam roller
718 axial screw
719 roller
720 rotation transmission ring
722 roller
724 manual focus ring
725 ultrasonic motor
726 waved washer
727 ball race
728 focus key
729 joining member
732 washer
733 low friction sheet
901 optical apparatus
908 release button
909 stroboscopic light emission unit
912 speaker
914 microphone
916 fill light unit
931 main body
932 zoom lever
933 power button
1100 ultrasonic probe
1101 piezoelectric element
1102 backing layer
1103 acoustic matching layer
1104 acoustic lens
1110 ultrasonic diagnostic apparatus
1111 cable
1112 image display unit
1113 drive control unit
1114 image processing unit
1120 ultrasonic diagnostic system
1121 transmission unit
1122 reception unit

## Claims

1. A piezoelectric element comprising a single crystal of a perovskite-type metal oxide and electrodes facing each other,
wherein when an environmental temperature is 25°C, a crystal system of the single crystal is a tetragonal system, and
wherein a crystal orientation of a surface of the single crystal in contact with each of electrode surfaces of the electrodes facing each other is (110) or (111).

2. The piezoelectric element according to claim 1, wherein the single crystal contains less than 1,000 ppm of Pb.

3. The piezoelectric element according to claim 1 or 2,
wherein the single crystal contains, as a main component, a perovskite-type metal oxide containing Ba, Ti, and Zr,
wherein when "x" represents a molar ratio of an amount of substance of the Zr to a total amount of an amount of substance of the Ti and the amount of substance of the Zr, 0.01≤x≤0.03 is satisfied,
wherein when α represents a molar ratio of an amount of substance of the Ba to the total amount of the amount of substance of the Ti and the amount of substance of the Zr, 0.976≤α≤1.020 is satisfied,
wherein the single crystal contains at least Mn and Bi,
wherein a content of the Mn is 0.0020 part by mole or more to 0.0500 part by mole or less with respect to 1 part by mole of the perovskite-type metal oxide containing Ba, Ti, and Zr, and
wherein a content of the Bi is 0.0005 part by mole or more to 0.0060 part by mole or less with respect to 1 part by mole of the perovskite-type metal oxide containing Ba, Ti, and Zr.

4. The piezoelectric element according to any one of claims 1 to 3,
wherein the single crystal contains a main component containing a perovskite-type metal oxide represented by the following general formula (1), a first sub-component formed of Mn, and a second sub-component formed of trivalent Bi,
wherein a content of the Mn is 0.0020 part by mole or more to 0.0500 part by mole or less with respect to 1 part by mole of the perovskite-type metal oxide represented by the general formula (1), and
wherein a content of the Bi is 0.0005 part by mole or more to 0.0060 part by mole or less with respect to 1 part by mole of the perovskite-type metal oxide represented by the general formula (1):
Ba_{α}(Ti₁₋ₓZrₓ)O₃ (1)
where 0.01≤x≤0.03 and 0.976≤α≤1.020 are satisfied.

5. The piezoelectric element according to any one of claims 1 to 4, wherein the piezoelectric element has a coercive electric field Ec of 10 kV/cm or more.

6. The piezoelectric element according to any one of claims 1 to 5, wherein the single crystal contains, as a main component, a perovskite-type metal oxide represented by the following general formula (2):
(1-y)Pb(Mg_{1/3}Nb_{2/3})O₃-yPbTiO₃ (2)
where 0.34≤y≤0.50 is satisfied.

7. The piezoelectric element according to any one of claims 1 to 6, wherein the single crystal contains, as a main component, a perovskite-type metal oxide represented by the following general formula (3):
(1-z)Pb(Zn_{1/3}Nb_{2/3})O₃-zPbTiO₃ (3)
where 0.12≤z≤0.20 is satisfied.

8. The piezoelectric element according to any one of claims 1 to 7, wherein when the environmental temperature is 0°C or more to 60°C or less, the crystal system of the perovskite-type metal oxide is tetragonal.

9. The piezoelectric element according to any one of claims 1 to 8,
wherein the crystal orientation of the surface of the single crystal in contact with the electrode surfaces of the electrodes facing each other is (110), and
wherein when the electrode surfaces of the electrodes facing each other are set as main surfaces of the piezoelectric element, a crystal orientation of a side surface of the piezoelectric element on a longitudinal direction side of the electrode surfaces is (001).

10. A method of producing a piezoelectric element, the method comprising:
a first preparation step of preparing a matrix and a seed single crystal;
a second preparation step of preparing an integrated body in which a surface of the matrix and a (110) plane or a (111) plane of the seed single crystal are arranged in contact with each other;
a first temperature-increasing step of increasing a temperature of the integrated body from room temperature to a liquid-phase start temperature of the matrix;
a second temperature-increasing step of increasing the temperature of the integrated body from the liquid-phase start temperature to a liquid-phase end temperature of the matrix;
a heating step of heating the integrated body at the liquid-phase end temperature;
a step of obtaining a single crystal from the integrated body after the heating;
a step of arranging electrodes facing each other on the single crystal to produce a piezoelectric element; and
a step of subjecting the piezoelectric element to polarization treatment,
wherein a rate of temperature increase in the second temperature-increasing step is lower than a rate of temperature increase in the first temperature-increasing step.

11. An ultrasonic motor comprising:
a vibrating body including the piezoelectric element of any one of claims 1 to 9, and
a moving body configured to be brought into contact with the vibrating body.

12. An optical apparatus comprising a drive unit including the ultrasonic motor of claim 11.

13. A vibration device comprising a vibrating body including a diaphragm including the piezoelectric element of any one of claims 1 to 9.

14. A dust removing device comprising a vibration unit including the vibration device of claim 13.

15. An image pickup apparatus comprising:
the dust removing device of claim 14; and
an image pickup element unit,
wherein the diaphragm of the dust removing device is arranged on a light-receiving surface side of the image pickup element unit.

16. An ultrasonic probe comprising the piezoelectric element of any one of claims 1 to 9, the ultrasonic probe being configured to transmit and receive a signal by the piezoelectric element.

17. An ultrasonic diagnostic apparatus comprising:
the ultrasonic probe of claim 16; and
an image output unit.

18. An ultrasonic diagnostic system comprising:
the ultrasonic probe of claim 16;
a transmission unit configured to transmit a signal output from the ultrasonic probe; and
a reception unit configured to receive the signal transmitted from the transmission unit.

19. An electronic apparatus comprising a piezoelectric acoustic component including the piezoelectric element of any one of claims 1 to 9.
